# EUROPEAN PATENT APPLICATION

(11) **EP 4 657 082 A1**
(43) Date of publication of application: **03.12.2025**
(21) Application number: 24747137.8
(22) Date of filing: 12.01.2024
(51) Int. Cl.: G01R 15/20

(54) **CURRENT SENSOR**

(30) Priority: 27.01.2023 JP 2023011077
(71) Applicant: DENSO CORPORATION, Kariya-city, Aichi 448-8661 (JP)
(72) Inventor: KANAZAWA, Takeru, Kariya-city, Aichi 4488661 (JP); ISOGAI, Hatsuomi, Kariya-city, Aichi 4488661 (JP); YAMADA, Akira, Kariya-city, Aichi 4488661 (JP); SASAKI, Akito, Kariya-city, Aichi 4488661 (JP); SHIZU, Atsuo, Kariya-city, Aichi 4488661 (JP); MIZUNO, Rira, Kariya-city, Aichi 4488661 (JP); TOKUNAGA, Kenji, Kariya-city, Aichi 4488661 (JP)
(74) Representative: Kuhnen & Wacker Patent- und Rechtsanwaltsbüro PartG mbB
(86) International application number: PCT/JP2024/000649
(87) International publication number: WO 2024/157806

(57) **Abstract**

A bus bar (10) of a current sensor includes a side face (111) of a current path portion (100) intersecting with a width direction (DW), a first extension portion (121) extending in the width direction (DW) from a region of the side face (111) where the current path portion protrudes from a case (50), a second extension portion (122) connected to the first extension portion (121) and extending in a direction intersecting with the direction in which the first extension portion extends, and when the current path portion (100) deforms in the thickness direction (DT), the second extension portion (122) deforms in a thickness direction (DT) while coming into contact with the case (50).

## Description

### CROSS REFERENCE TO RELATED APPLICATION

The present application is based on Japanese Patent Application No. 2023-011077 filed on January 27, 2023. The entire disclosures of all of the above applications are incorporated herein by reference.

### TECHNICAL FIELD

The present disclosure relates to a current sensor.

### BACKGROUND ART

As described in Patent Literature 1, a current sensor is known that includes a bus bar, a core, a sensor chip as a detection element, a case, and a connection terminal as a terminal. In such current sensor, an electric current flows through the bus bar. The core receives the bus bar inserted thereinto. Further, a magnetic field generated by an electric current flowing through the bus bar passes through the core. The sensor chip is arranged in a gap formed in the core. Further, the sensor chip detects the intensity of the magnetic field passing through the gap, thereby detecting the electric current flowing through the bus bar. The case accommodates the bus bar, the core, and the sensor chip. The connection terminal is electrically connected to the sensor chip, and outputs a signal from the sensor chip to an external device.

### PRIOR ART LITERATURE

### PATENT LITERATURE

PATENT LITERATURE 1: JP2018-51704A

### SUMMARY OF INVENTION

According to a study by the inventor and others, when the bus bar of the current sensor described in Patent Literature 1 is connected to a detection target by a bolt or the like, the bus bar is deformed. At such time, stress is applied to the bus bar, which in turn applies stress to the case accommodating the bus bar. In such manner, the case may be damaged.

It is an object of the present disclosure to provide a current sensor that suppresses damage to the case.

According to one aspect of the present disclosure, a current sensor comprises: a bus bar in a plate shape and including a current path portion configured to cause an electric current to flow therethrough; a core including a core hole into which the current path portion is inserted, a gap forming portion having a first end face facing in a width direction of the current path portion, a second end face facing the first end face in the width direction, and a gap defined by the first end face and the second end face and communicating with the core hole and an outside, a core side portion connected to the gap forming portion and extending in a thickness direction of the current path portion, and a core bottom portion connected to the core side portion, extending in the width direction, and defining the core hole with the gap forming portion and the core side portion; a detection element arranged in the gap and configured to detect an intensity of a magnetic field generated by an electric current flowing through the current path portion; and a case accommodating a portion of the bus bar, the core, and the detection element. The bus bar includes a side face that is of the current path portion and intersects with the width direction, a first extension portion that extends in the width direction from a region of the side face where the current path portion protrudes from the case, and a second extension portion that is connected to the first extension portion and extends in a direction intersecting with an extending direction in which the first extension portion extends. The second extension portion is configured to deform in the thickness direction while coming into contact with the case when the current path portion deforms in the thickness direction.

According to another aspect of the present disclosure, a current sensor comprises: a bus bar in a plate shape and including a current path portion configured to cause an electric current to flow therethrough; a core including a core hole into which the current path portion is inserted, a gap forming portion having a first end face facing in a width direction of the current path portion, a second end face facing the first end face in the width direction, and a gap defined by the first end face and the second end face and communicating with the core hole and an outside, a core side portion connected to the gap forming portion and extending in a thickness direction of the current path portion, and a core bottom portion connected to the core side portion, extending in the width direction, and defining the core hole with the gap forming portion and the core side portion; a detection element arranged in the gap and configured to detect an intensity of a magnetic field generated by an electric current flowing through the current path portion; and a case accommodating a portion of the bus bar, the core, and the detection element. The bus bar includes a side face that is of the current path portion and intersects with the width direction, a first extension portion that extends in the width direction from a region of the side face where the current path portion protrudes from the case, and a second extension portion that is connected to the first extension portion and extends in a direction intersecting with an extending direction in which the first extension portion extends. A cross-sectional area of the second extension portion taken along a direction perpendicular to a longitudinal direction of the current path portion is smaller than a cross-sectional area of the current path portion taken along a direction perpendicular to the longitudinal direction.

According to yet another aspect of the present disclosure, a current sensor comprises: a bus bar in a plate shape and including a current path portion configured to cause an electric current to flow therethrough; a core including a core hole into which the current path portion is inserted, a gap forming portion having a first end face facing in a width direction of the current path portion, a second end face facing the first end face in the width direction, and a gap defined by the first end face and the second end face and communicating with the core hole and an outside, a core side portion connected to the gap forming portion and extending in a thickness direction of the current path portion, and a core bottom portion connected to the core side portion, extending in the width direction, and defining the core hole with the gap forming portion and the core side portion; a detection element arranged in the gap and configured to detect an intensity of a magnetic field generated by an electric current flowing through the current path portion; and a case accommodating a portion of the bus bar, the core, and the detection element. The bus bar includes a side face that is of the current path portion and intersects with the width direction, a first extension portion that extends in the width direction from a region of the side face where the current path portion protrudes from the case, an intermediate portion that is connected to the first extension portion and extends in a direction intersecting with an extending direction in which the first extension portion extends, and a second extension portion that is connected to the intermediate portion and extends in a direction intersecting with an extending direction in which the the intermediate portion extends. The second extension portion is configured to deform in the thickness direction while coming into contact with the case when the current path portion deforms in the thickness direction.

In such manner, the second extension portion is easily deformable, and therefore easily absorbs stress energy generated by deformation of the bus bar when connecting the bus bar to a detection target. Therefore, the stress applied to the case accommodating a part of the bus bar, the core, and the detection element is reducible. Thus, damage to the case is suppressed.

Note that a reference numeral in parentheses attached to each element or the like indicates an example of correspondence between the element or the like and specific element or the like described in the embodiments described in the following.

### BRIEF DESCRIPTION OF THE DRAWINGS

FIG. 1 is a perspective view of a current sensor according to a first embodiment.
FIG. 2 is a view taken along a line II in FIG. 1.
FIG. 3 is a view taken along a line III in FIG. 1.
FIG. 4 is a view taken along a line IV in FIG. 1.
FIG. 5 is a view taken along an arrow V in FIG. 1.
FIG. 6 is a view taken along a line VI in FIG. 1.
FIG. 7 is a cross-sectional view taken along a line VII - VII in FIG. 1.
FIG. 8 is an enlarged view of a portion VIII in FIG. 7.
FIG. 9 is a cross-sectional view taken along a line IX - IX in FIG. 7.
FIG. 10 is an enlarged view of a part X in FIG. 7.
FIG. 11 is an enlarged perspective view of a bus bar of the current sensor.
FIG. 12 is a cross-sectional view taken along a line XII - XII in FIG. 11.
FIG. 13 is an enlarged view of a part XIII in FIG. 12.
FIG. 14 is an enlarged view of a part XIV in FIG. 12.
FIG. 15 is an enlarged view of a part XV in FIG. 12.
FIG. 16 is a cross-sectional view taken along a line XVI - XVI in FIG. 15.
FIG. 17 is an enlarged view of a part XVII in FIG. 4.
FIG. 18 is an enlarged cross-sectional view taken along a line XVIII - XVIII in FIG. 17.
FIG. 19 is an enlarged cross-sectional view taken along a line XIX - XIX in FIG. 17.
FIG. 20 is a view taken along a line XX in FIG. 1.
FIG. 21 is a perspective view showing deformations of a second extension portion and a fourth extension portion of the bus bar of the current sensor.
FIG. 22 is a cross-sectional view showing the attachment of a substrate to a case of the current sensor.
FIG. 23 is a cross-sectional view of a current sensor of a comparative example.
FIG. 24 is a perspective view of a current sensor according to a second embodiment.
FIG. 25 is a view taken along an arrow XXV in FIG. 24.
FIG. 26 is an external view of a current sensor according to a third embodiment.
FIG. 27 is an enlarged view of a part XXVII in FIG. 26.
FIG. 28 is an external view showing a state in which the bus bar of the current sensor is inserted into the case.
FIG. 29 is an external view of a bus bar in a current sensor according to a modified example of the third embodiment.
FIG. 30 is an external view of a bus bar in a current sensor according to a modified example of the third embodiment.
FIG. 31 is an external view of a bus bar in a current sensor according to a modified example of the third embodiment.
FIG. 32 is an external view of a current sensor according to a fourth embodiment.
FIG. 33 is an external view of a current sensor.
FIG. 34 is an external view of a current sensor according to a fifth embodiment.
FIG. 35 is an enlarged cross-sectional view of a proximity of the bus bar of the current sensor.
FIG. 36 is an external view of a current sensor according to a sixth embodiment.
FIG. 37 is an enlarged cross-sectional view of the proximity of a core in a current sensor according to a seventh embodiment.
FIG. 38 is an enlarged cross-sectional view of the proximity of a bus bar of the current sensor of an eighth embodiment.
FIG. 39 is a cross-sectional view of a current sensor according to a ninth embodiment.
FIG. 40 is an enlarged view of a part XL of FIG. 39.
FIG. 41 is an enlarged cross-sectional view of a substrate and a case of a current sensor according to a tenth embodiment.
FIG. 42 is an enlarged cross-sectional view of a substrate and a case of a current sensor according to an eleventh embodiment.
FIG. 43 is a cross-sectional view of a proximity of a terminal of a current sensor according to a twelfth embodiment.

### DESCRIPTION OF EMBODIMENTS

Hereinafter, embodiments will be described with reference to the drawings.
In the following embodiments, the same or equivalent portions are denoted by the same reference numerals, and the description thereof will be omitted.

### (First Embodiment)

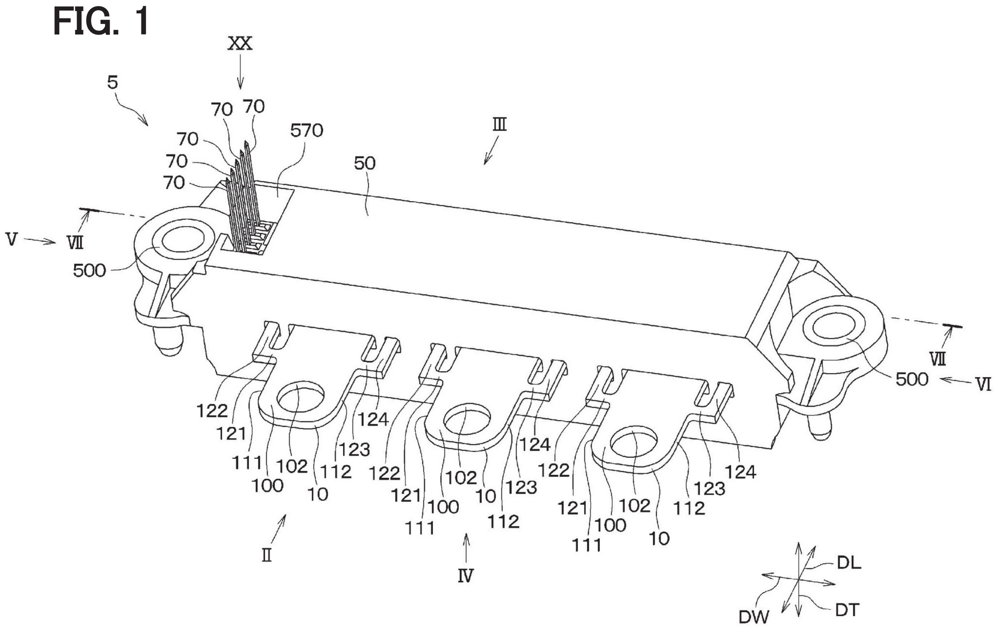

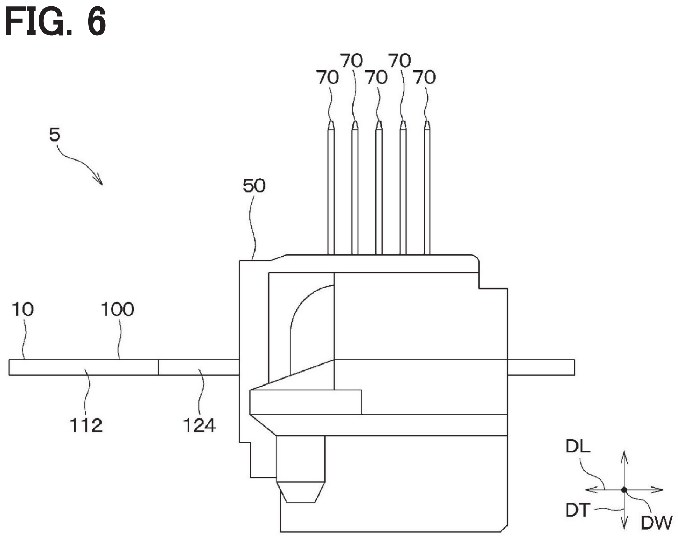

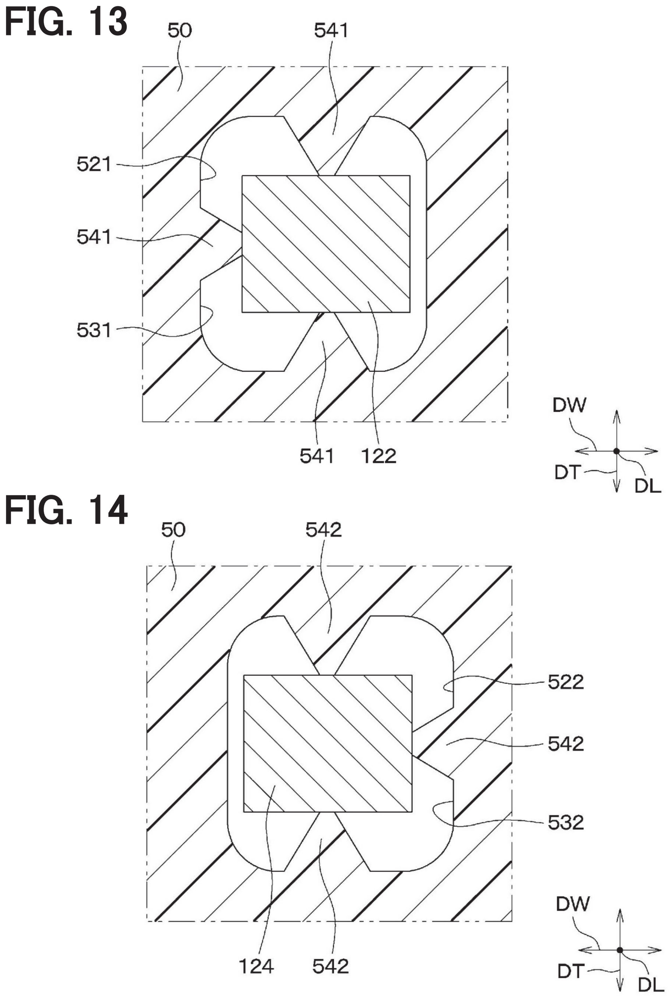

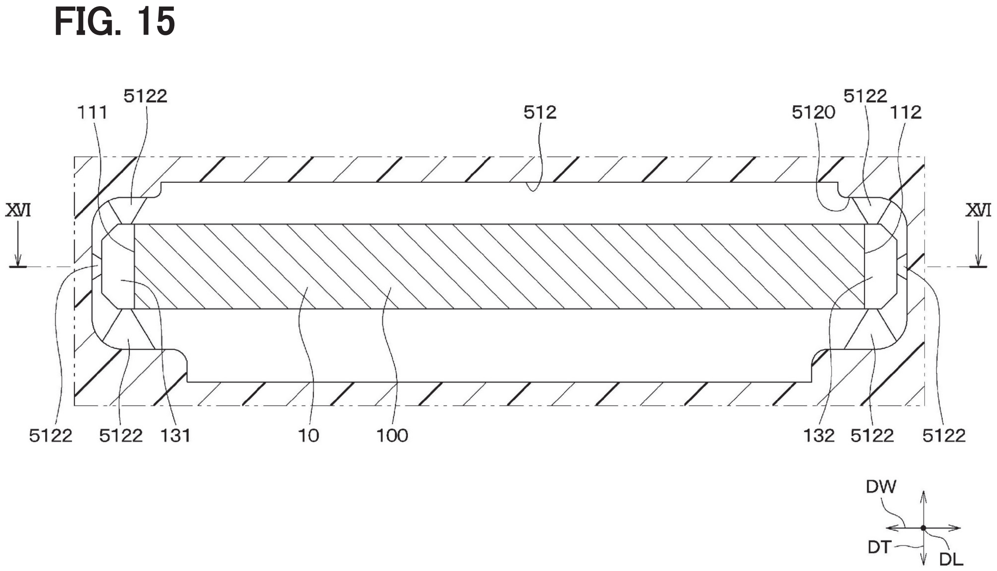

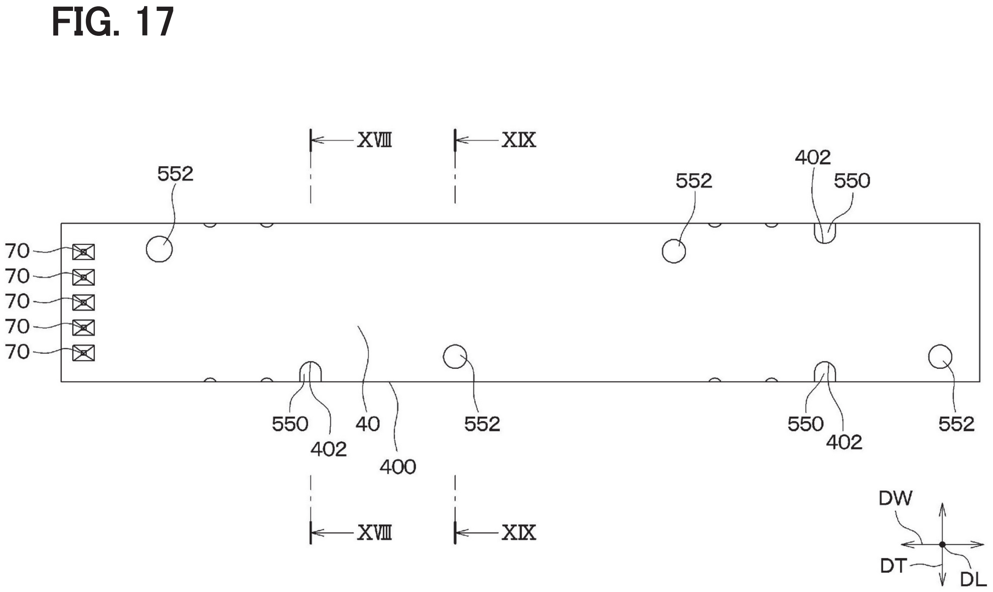

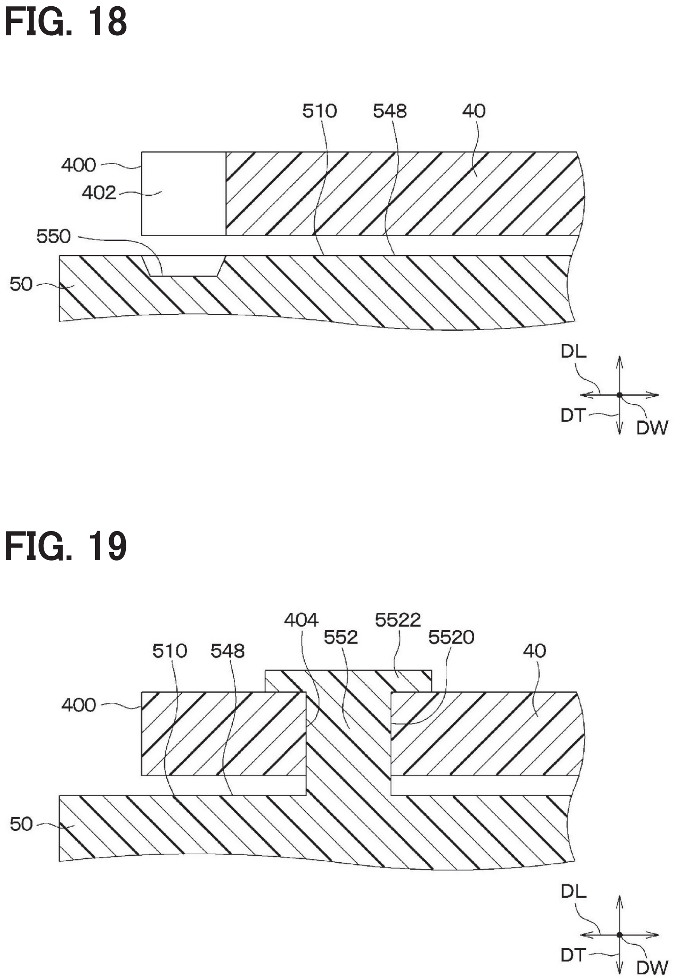

The current sensor of the present embodiment is used, for example, in an inverter that drives a three-phase AC motor mounted on a vehicle (not shown). Specifically, as shown in FIGS. 1 to 20, a current sensor 5 includes a bus bar 10, a core 20, a detection portion 30, a lead wire 35, a substrate 40, a case 50, a resin filler 60, and a terminal 70.

The bus bar 10 is formed in a plate shape. Further, the bus bar 10 is made of copper or the like, and is therefore conductive. Further, a surface of the bus bar 10 is plated as necessary to prevent oxidation of the surface. The number of bus bars 10 corresponds to the number of phases of the motor and inverter. Here, since the number of phases of the motor and the inverter is three, the number of bus bars 10 is three. Further, the three bus bars 10 are arranged at intervals in the width direction DW of the bus bars 10.

As shown in FIGS. 1 to 9 and 11 to 16, the bus bar 10 has a current path portion 100, a fastening portion 102, a first side face 111, a first extension portion 121 and a second extension portion 122. Further, the bus bar 10 has a second side face 112, a third extension portion 123, a fourth extension portion 124, a first bus bar protrusion 131 and a second bus bar protrusion 132.

The current path portion 100 is formed in a plate shape. The fastening portion 102 is, for example, a hole extending in a thickness direction DT, and is connected to each phase of the inverter. Therefore, an electric current from respective phases of the inverter flow through respective current path portions 100.

Hereinafter, for convenience, a longitudinal direction DL of the current path portion 100 will be simply referred to as the longitudinal direction DL. Further, a width direction DW of the current path portion 100 will be simply referred to as the width direction DW. Further, a thickness direction DT of the current path portion 100 will be simply referred to as the thickness direction DT.

The first side face 111 is a surface of the current path portion 100 that is perpendicular to the width direction DW, and corresponds to a surface of the current path portion 100 that intersects with the width direction DW.

The first extension portion 121 extends in the width direction DW from a region of a portion of the first side face 111 where the current path portion 100 protrudes from the case 50 described below.

The second extension portion 122 is connected to a side of the first extension portion 121 opposite to the first side face 111. Further, the second extension portion 122 extends from the first extension portion 121 in a direction intersecting with a direction in which the first extension portion 121 extends, which is the longitudinal direction DL here. Further, when the current path portion 100 undergoes elastic deformation, plastic deformation, or the like in the thickness direction DT, the second extension portion 122 deforms in the thickness direction DT while coming into contact with the case 50 described below.

Further, a length of the second extension portion 122 in the width direction DW is shorter than a length of the current path portion 100 in the width direction DW. Further, a cross-sectional area of the second extension portion 122 when cut in a direction perpendicular to the longitudinal direction DL is smaller than a cross-sectional area of the current path portion 100 when cut in a direction perpendicular to the longitudinal direction DL. Therefore, the second extension portion 122 is more easily deformed than the current path portion 100.

The second side face 112 is positioned on an opposite side of the first side face 111. The second side face 112 is a surface of the current path portion 100 that is perpendicular to the width direction thereof and that intersects with the width direction DW thereof.

The third extension portion 123 extends in the width direction DW from a region of a portion of the second side face 112 where the current path portion 100 protrudes from the case 50 described below.

The fourth extension portion 124 is connected to the third extension portion 123 on an opposite side to the second side face 112. Further, the fourth extension portion 124 extends from the third extension portion 123 in a direction intersecting with the direction in which the third extension portion 123 extends, which is the longitudinal direction DL here. Further, when the current path portion 100 undergoes elastic deformation, plastic deformation, or other deformation in the thickness direction DT, the fourth extension portion 124 deforms in the thickness direction DT while coming into contact with the case 50 described below.

Further, a length of the fourth extension portion 124 in the width direction DW is shorter than a length of the current path portion 100 in the width direction DW. Further, a cross-sectional area of the fourth extension portion 124 when cut in a direction perpendicular to the longitudinal direction DL is smaller than a cross-sectional area of the current path portion 100 when cut in a direction perpendicular to the longitudinal direction DL. Therefore, the fourth extension portion 124 is more easily deformed than the current path portion 100.

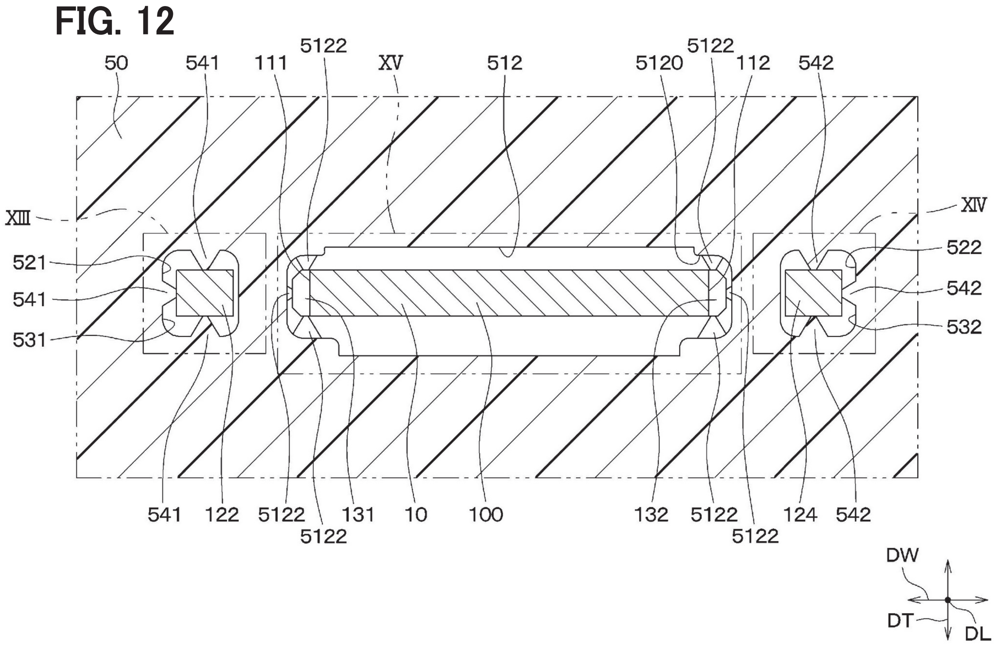

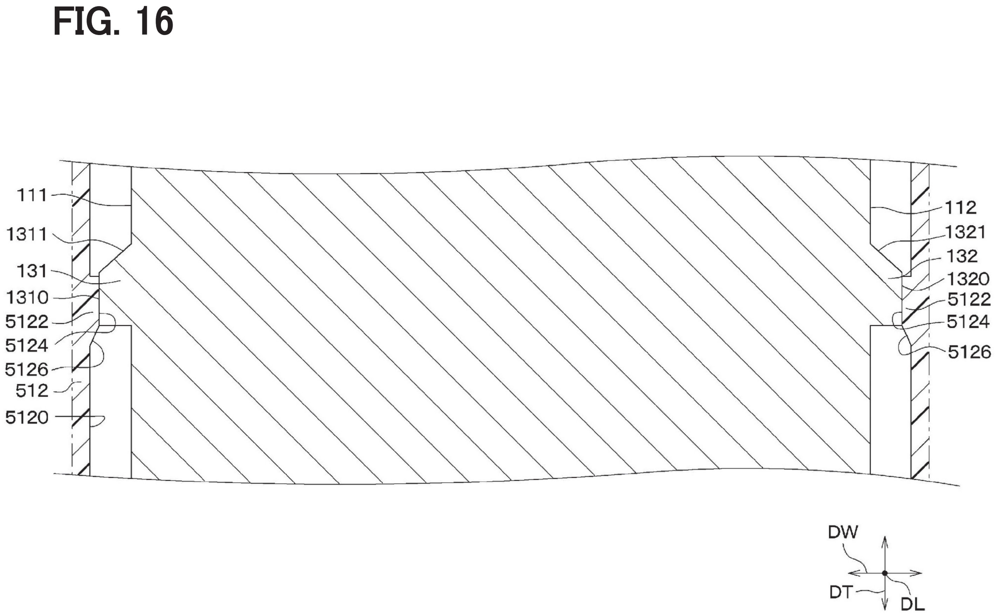

As shown in FIGS. 12, 15 and 16, the first bus bar protrusion 131 protrudes in the width direction DW from a region of the first side face 111 that is accommodated in the case 50, which will be described later. Further, as shown in FIG. 16, the first bus bar protrusion 131 includes a first contact portion 1310 and a first inclined portion 1311.

The first contact portion 1310 is a portion of the first bus bar protrusion 131 that is in contact with the case 50 described below. The first inclined portion 1311 is connected to the first contact portion 1310 on an opposite side to the fastening portion 102. Further, the first inclined portion 1311 is inclined in a direction in which a size of the first bus bar protrusion 131 decreases with increasing distance from a boundary with the first contact portion 1310.

As shown in FIGS. 12, 15 and 16, the second bus bar protrusion 132 protrudes in the width direction DW from a region of the second side face 112 that is accommodated in the case 50, which will be described later. Further, as shown in FIG. 16, the second bus bar protrusion 132 includes a second contact portion 1320 and a second inclined portion 1321.

The second contact portion 1320 is a portion of the second bus bar protrusion 132 that is in contact with the case 50 described below. The second inclined portion 1321 is connected to the second contact portion 1320 on an opposite side to the fastening portion 102. Further, the second inclined portion 1321 is inclined in a direction in which a size of the second bus bar protrusion 132 decreases with increasing distance from a boundary with the second contact portion 1320.

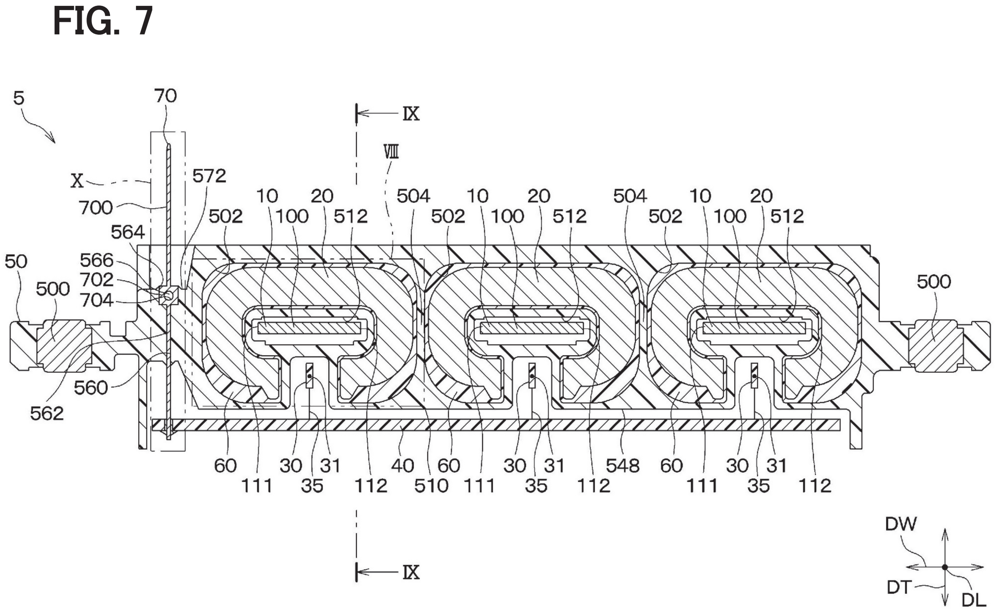

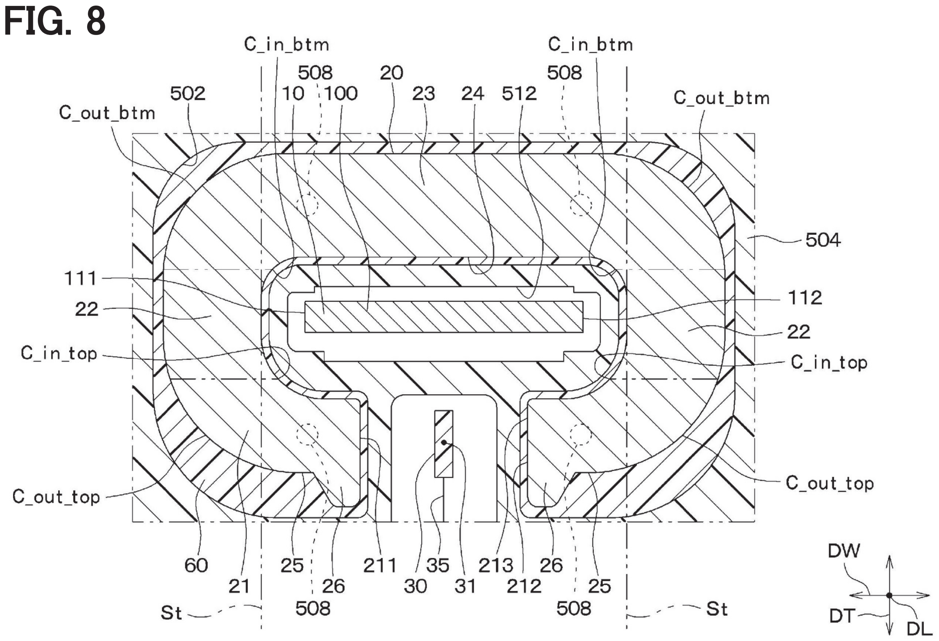

As shown in FIGS. 7 and 8, the core 20 is formed in a C-shape and is made of a soft magnetic material such as permalloy, grain-oriented electromagnetic steel sheet or the like. Further, the core 20 is formed, for example, by bending a plate-shaped soft magnetic material into a C-shape. Further, the number of cores 20 corresponds to the number of bus bars 10. Here, since the number of bus bars 10 is three, the number of cores 20 is three. Further, since the bus bars 10 are arranged at intervals in the width direction DW, the three cores 20 are arranged at intervals in the width direction DW. Further, a magnetic field generated by an electric current flowing through each bus bar 10 passes through each core 20. Also, as shown in FIG. 8, the core 20 has a gap forming portion 21, a core side portion 22, a core bottom portion 23, a core hole 24, a core outer surface 25, and a core protrusion 26.

The gap forming portion 21 is formed in a plate shape extending in the width direction DW. Further, a lateral outer corner C_out_top, which is an outer corner in the width direction DW of the gap forming portion 21, has an R shape. Further, the gap forming portion 21 includes a first end face 211, a second end face 212, and a gap 213.

The first end face 211 faces the width direction DW. The second end face 212 faces the width direction DW, and faces the first end face 211 in the width direction DW. Further, when the first end face 211 is projected in the width direction DW, the second end face 212 overlaps with the projected first end face 211. The gap 213 is a space defined by the first end face 211 and the second end face 212. Further, the gap 213 communicates with an outside of the core 20 and with the core hole 24 which will be described later.

The core side portion 22 is connected to the gap forming portion 21. Further, the core side portion 22 extends in the thickness direction DT from a boundary between the core side portion 22 and the gap forming portion 21. Further, a lateral inner corner C_in_top, which is an inner corner at a boundary between the core side portion 22 and the gap forming portion 21, has an R shape. Further, the core side portion 22 is separated from the current path portion 100 in the width direction DW.

The core bottom portion 23 is connected to the core side portion 22. Further, the core bottom portion 23 extends in the width direction DW. Further, a bottom outer corner C_out_btm, which is an outer corner of the core bottom portion 23 in the width direction DW, has an R shape. Further, a bottom inner corner C_in_btm, which is an inner corner at a boundary between the core bottom portion 23 and the core side portion 22, has an R shape. Further, the core bottom portion 23 is separated from the current path portion 100 in the thickness direction DT.

The core hole 24 is defined by the gap forming portion 21, the core side portion 22 and the core bottom portion 23. Further, a portion of each bus bar 10 is inserted into the space of each core hole 24.

The core outer surface 25 is an outer surface of the gap forming portion 21, and is a surface of the gap forming portion 21 facing outside in the thickness direction DT.

Here, a plane passing through an inner edge of the core side portion 22 extending in the thickness direction DT and perpendicular to the width direction DW is defined as a passing plane St. Further, since the core side portions 22 are arranged in the width direction DW, the passing surfaces St are arranged in the width direction DW.

The core protrusion 26 protrudes in the thickness direction DT from a region between adjacent passing surfaces St on the core outer surface 25. Although the number of core protrusions 26 is two, the number is not limited to such configuration. The number of the core protrusions 26 may be at least one. Further, although the shape of the core protrusion 26 is a quadrangular prism, the shape is not limited to such configuration. The shape of the core protrusion 26 may be, for example, a polygonal prism shape, a columnar shape or the like.

The detection portion 30 is arranged in the gap 213 as shown in FIGS. 7 and 8. Therefore, when the first end face 211 is projected in the width direction DW, the detection portion 30 overlaps with the projected first end face 211. Further, when the second end face 212 is projected in the width direction DW, the detection portion 30 overlaps with the projected second end face 212. Further, the detection portion 30 includes a detection element 31 and an IC (not shown). It should be noted that IC is an abbreviation for Integrated Circuit.

The detection element 31 is a Hall element, a TMR element, a GMR element, an AMR element, or the like. Further, the detection element 31 detects an intensity of the magnetic field in the width direction DW. Further, the detection element 31 outputs to an outside a signal corresponding to the intensity of the detected magnetic field, for example, a voltage corresponding to the intensity of the detected magnetic field. It should be noted that TMR is an abbreviation for Tunnel Magneto Resistive. GMR stands for Giant Magneto Resistive. AMR stands for Anisotropic Magneto Resistive.

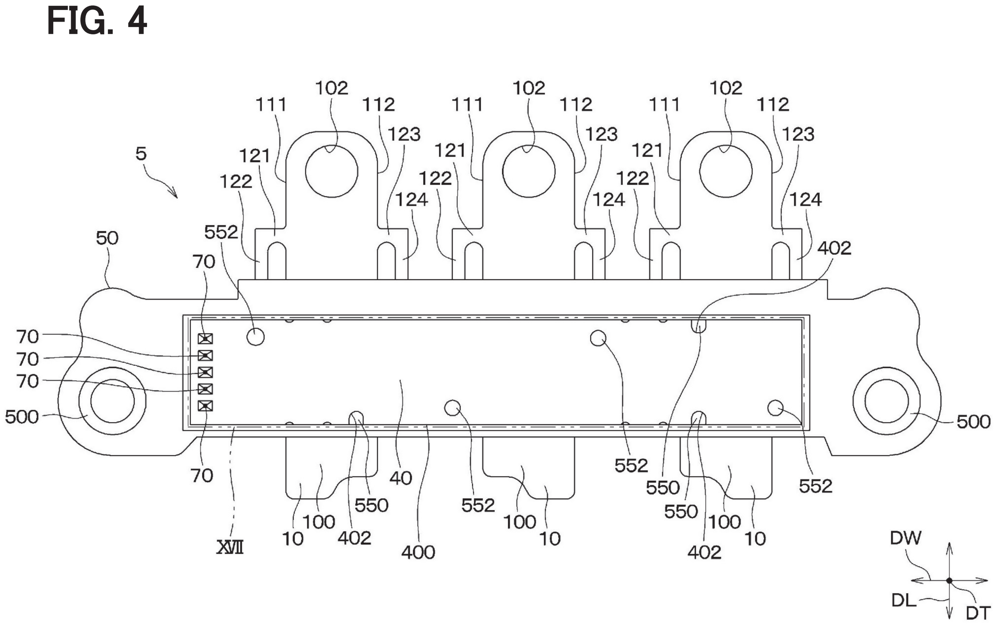

The lead wire 35 is connected to the detection portion 30. The substrate 40 is a printed circuit board. Further, as shown in FIG. 7, the substrate 40 is connected to the lead wire 35 by soldering or the like. Further, as shown in FIGS. 4, 17, 18 and 19, the substrate 40 has a substrate side face 400, a substrate notch 402 and a substrate hole 404.

The substrate side face 400 corresponds to a surface that is perpendicular to the longitudinal direction DL or the width direction DW, and intersects with the longitudinal direction DL or the width direction DW. In such case, since the thickness direction of the substrate 40 coincides with the thickness direction DT of the current path portion 100, the substrate side face 400 is a surface that intersects with the longitudinal direction DL or the width direction DW. On the other hand, the thickness direction of the substrate 40 does not necessarily have to coincide with the thickness direction DT of the current path portion 100. The thickness direction of the substrate 40 may, for example, coincide with the longitudinal direction DL of the current path portion 100. In such case, the substrate side face 400 corresponds to a surface intersecting with the thickness direction DT or the width direction DW.

The substrate notch 402 is recessed from the substrate side face 400, i.e., is recessed in the longitudinal direction DL from the substrate side face 400 perpendicular to the longitudinal direction DL. Further, the substrate notch 402 is formed in an arc shape. The substrate notch 402 may be recessed in the width direction DW from the substrate side face 400 perpendicular to the width direction DW. Here, the shape of the substrate notch 402 is an elliptical arc. In contrast, the shape of the substrate notch 402 is not limited to an elliptical arc shape. The shape of the substrate notch 402 may be a polygon, a circular arc, an elliptical arc, or the like. Further, while the number of substrate notches 402 is three here, the number is not limited to such configuration. The number of substrate notches 402 may be at least one, and it is preferable that the number be three or more so that a plane is formed by straight lines connecting the substrate notches 402 with each other.

The substrate hole 404 is a through hole that penetrates an inside of the substrate 40 in the thickness direction DT. In such case, the shape of the substrate hole 404 is columnar. In contrast, the shape of the substrate hole 404 is not limited to being columnar. The shape of the substrate hole 404 may be a polygonal column, an elliptical column, or the like. Also, while the number of substrate holes 404 is four here, the number is not limited to such configuration. The number of substrate holes 404 may be at least one, and it is preferable that the number be three or more so that a plane is formed by straight lines connecting the substrate holes 404 with each other. Further, here, since the thickness direction of the substrate 40 coincides with the thickness direction DT of the current path portion 100, the substrate hole 404 penetrates the inside of the substrate 40 in the thickness direction DT. On the other hand, the thickness direction of the substrate 40 does not necessarily have to coincide with the thickness direction DT of the current path portion 100. The thickness direction of the substrate 40 may, for example, coincide with the longitudinal direction DL of the current path portion 100. In such case, the substrate hole 404 penetrates the inside of the substrate 40 in the longitudinal direction DL.

The case 50 is formed by injection molding using a thermoplastic resin such as polybutylene terephthalate. Further, the case 50 accommodates the bus bar 10, the core 20, the detection portion 30, the lead wire 35, the substrate 40, the resin filler 60 and the terminal 70, which will be described later. Further, as shown in FIGS. 1 to 4, since the bus bar 10, the core 20, etc. are arranged in the width direction DW, a length of the case 50 in the width direction DW is longer than a length of the case 50 in the longitudinal direction DL.

Further, the case 50 has a collar 500, a core accommodating chamber 502, a partition portion 504, a case facing surface 506, a case protrusion 508, and a substrate accommodating chamber 510. Further, the case 50 has an opening 512, a first inner surface 521, a first hole 531, a first protrusion 541, a second inner surface 522, a second hole 532 and a second protrusion 542. The case 50 also has an accommodating chamber facing surface 548, a substrate recess 550, and a substrate protrusion 552. The case 50 further includes a terminal hole 560, a terminal inner surface 562, a terminal recess 564 and a terminal protrusion 566. The case 50 yet further includes a liquid drain recess 570 and a liquid discharge portion 580.

As shown in FIGS. 1, 4 and 7, the collar 500 is made of metal or the like, and has an annular shape. Further, a shaft or the like (not shown) is inserted into the collar 500 to connect the case 50 to an outside of the current sensor 5. In such manner, the current sensor 5 and the outside thereof are fixed.

As shown in FIGS. 7 and 8, the core 20 is accommodated in a space of the core accommodating chamber 502. The partition portion 504 is formed at a position between adjacent cores 20, and has a plate shape extending in the longitudinal direction DL and the thickness direction DT. In such manner, the adjacent core accommodating chambers 502 are divided from each other.

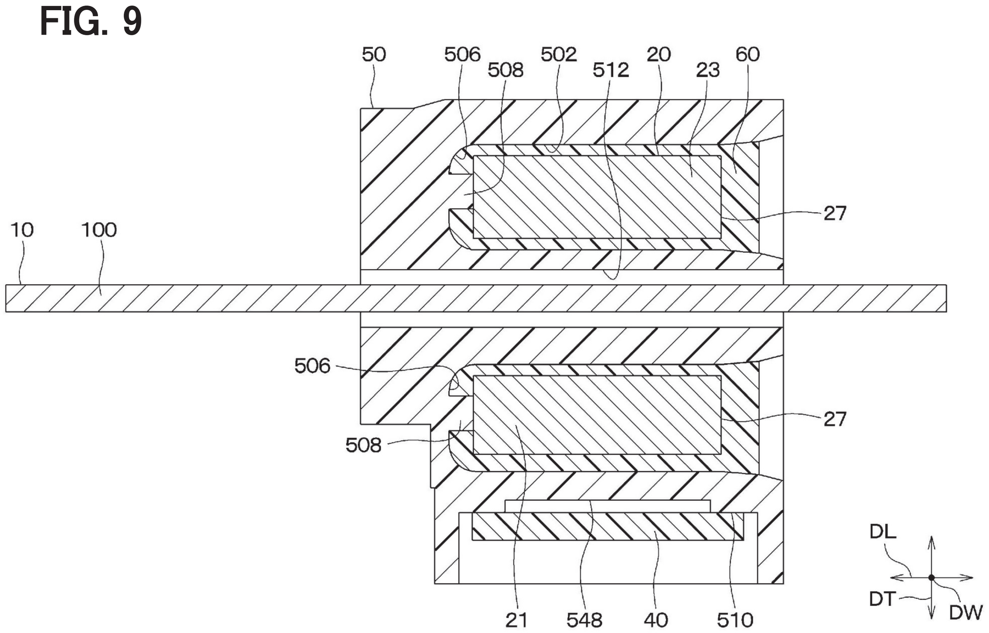

As shown in FIG. 9, the case facing surface 506 is a surface that faces the core 20 in the longitudinal direction DL, from among the inner surfaces forming the core accommodating chamber 502.

The case protrusion 508 protrudes toward the core 20 from the inner surface that forms the core accommodating chamber 502. Here, the case protrusion 508 protrudes from the case facing surface 506 in the longitudinal direction DL. In such manner, the case protrusion 508 is in contact with the core 20. Therefore, it makes positioning of the case 50 to the core 20 easier. Further, a space is formed at a position between the case facing surface 506 and the core 20. It should be noted that, although the number of case protrusions 508 is four as shown in FIG. 8, the number is not limited to four. The number of case protrusions 508 may be at least one, and it is preferable that the number be three or more so that a plane is formed by straight lines connecting the case protrusions 508 with each other. Here, the case protrusion 508 has a columnar shape. On the other hand, the shape of the case protrusion 508 is not limited to a columnar shape. The shape of the case protrusion 508 may be, for example, a polygonal column shape or an elliptical column shape.

As shown in FIG. 7, the detection portion 30, the lead wire 35, and the substrate 40 are accommodated in the space of the substrate accommodating chamber 510. Further, since the detection portion 30 is arranged in the gap 213, the substrate accommodating chamber 510 is formed on a gap 213 side of the case 50.

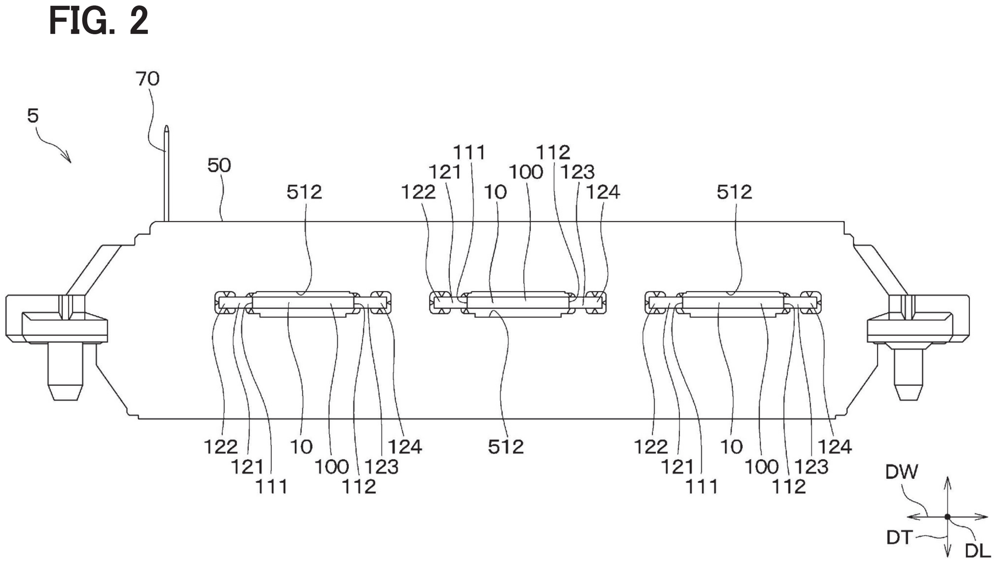

A portion of the opening 512 is inserted into the core hole 24 as shown in FIGS. 2, 3, 7 and 8. Further, a portion of the current path portion 100 is inserted into the space of the opening 512. In the present embodiment, the opening 512 has a polygonal cylindrical shape. On the other hand, the shape of the opening 512 is not limited to a polygonal cylindrical shape. The shape of the opening 512 may be cylindrical or the like.

Further, the opening 512 includes an opening face 5120 and an opening protrusion 5122, as shown in FIGS. 12, 15 and 16.

The opening face 5120 faces the current path portion 100 in the width direction DW and the thickness direction DT. The opening protrusion 5122 protrudes from the opening face 5120 toward the current path portion 100, thereby coming into contact with the first bus bar protrusion 131 and the second bus bar protrusion 132. Specifically, the opening protrusion 5122 protrudes from the opening face 5120 in the thickness direction DT. In such manner, the opening protrusion 5122 is in contact with the first bus bar protrusion 131 and the second bus bar protrusion 132 in the thickness direction DT. Further, the opening protrusion 5122 protrudes from the opening face 5120 in the width direction DW. Therefore, the opening protrusion 5122 is in contact with the first bus bar protrusion 131 and the second bus bar protrusion 132 in the width direction DW. In such manner, positioning of the bus bar 10 to the case 50 is made. Further, a space is formed at a position between the opening face 5120 and the current path portion 100. In the present embodiment, the opening protrusion 5122 has a triangular prism shape. On the other hand, the shape of the opening protrusion 5122 is not limited to a triangular prism shape. The shape of the opening protrusion 5122 may be, for example, a polygonal prism shape, a columnar shape or the like.

Further, the Young's modulus of the opening protrusion 5122 is smaller than the Young's modulus of the first bus bar protrusion 131 and the second bus bar protrusion 132. In such manner, the opening protrusions 5122 are more easily deformable than the first bus bar protrusions 131 and the second bus bar protrusions 132. The Young's modulus of the opening protrusion 5122 is estimated from the Young's modulus of the material of the case 50, for example. Further, the Young's modulus of the first bus bar protrusion 131 and the second bus bar protrusion 132 is estimated from the Young's modulus of the material of the bus bar 10, for example.

Further, the opening protrusion 5122 includes a protrusion contact portion 5124 and a protrusion inclined portion 5126 as shown in FIG. 16. The protrusion contact portion 5124 is a portion of the opening protrusion 5122 that is in contact with the first bus bar protrusion 131 and the second bus bar protrusion 132. The protrusion inclined portion 5126 is connected to the protrusion contact portion 5124 on a fastening portion 102 side. Further, the protrusion inclined portion 5126 is inclined in a direction in which a size of the opening protrusion 5122 becomes smaller with increasing distance from a boundary with the protrusion contact portion 5124.

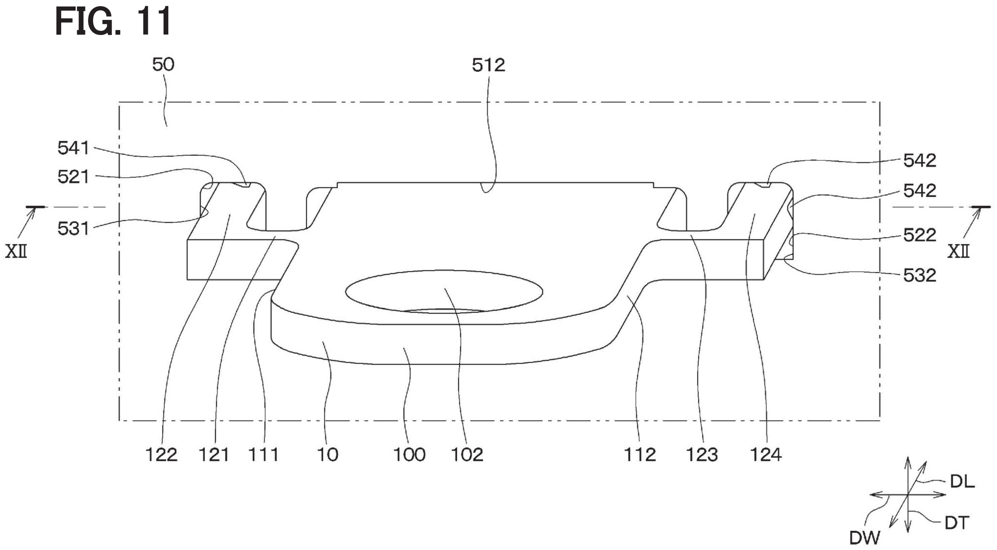

The first inner surface 521 forms the first hole 531 as shown in FIGS. 11, 12 and 13. Further, at least a portion of the second extension portion 122 is inserted into the space of the first hole 531. Therefore, the first inner surface 521 faces the second extension portion 122 in the width direction DW and the thickness direction DT.

The first protrusion 541 protrudes from the first inner surface 521 toward the second extension portion 122, thereby contacting the second extension portion 122. Specifically, the first protrusion 541 protrudes in the thickness direction DT from a portion of the first inner surface 521 that faces the second extension portion 122 in the thickness direction DT. In such manner, the first protrusion 541 is in contact with the second extension portion 122 in the thickness direction DT. Further, the first protrusion 541 protrudes in the width direction DW from a portion of the first inner surface 521 facing the second extension portion 122 in the width direction DW. Therefore, the first protrusion 541 is in contact with the second extension portion 122 in the width direction DW. According to the above, positioning of the case 50 and the second extension portion 122 are performed, thereby positioning of the case 50 and the bus bar 10 is performed. Here, the shape of the first protrusion 541 is a triangular prism. On the other hand, the shape of the first protrusion 541 is not limited to a triangular prism shape. The shape of the first protrusion 541 may be, for example, a polygonal prism shape, a columnar shape or the like.

The second inner surface 522 forms the second hole 532 as shown in FIGS. 11, 12 and 14. Further, at least a portion of the fourth extension portion 124 is inserted into the space of the second hole 532. Therefore, the second inner surface 522 faces the fourth extension portion 124 in the width direction DW and the thickness direction DT.

The second protrusion 542 protrudes from the second inner surface 522 toward the fourth extension portion 124, thereby contacting the fourth extension portion 124. Specifically, the second protrusion 542 protrudes in the thickness direction DT from a portion of the second inner surface 522 that faces the fourth extension portion 124 in the thickness direction DT. In such manner, the second protrusion 542 is in contact with the fourth extension portion 124 in the thickness direction DT. Further, the second protrusion 542 protrudes in the width direction DW from a portion of the second inner surface 522 facing the fourth extension portion 124 in the width direction DW. Therefore, the second protrusion 542 is in contact with the fourth extension portion 124 in the width direction DW. According to the above, positioning of the case 50 and the fourth extension portion 124 is performed, thereby positioning of the case 50 and the bus bar 10 is performed. Here, the shape of the second protrusion 542 is a triangular prism. On the other hand, the shape of the second protrusion 542 is not limited to a triangular prism shape. The shape of the second protrusion 542 may be, for example, a polygonal prism shape, a columnar shape or the like.

As shown in FIGS. 7, 9, 18 and 19, the accommodating chamber facing surface 548 is a surface that forms the substrate accommodating chamber 510, and faces the substrate 40 in the thickness direction DT. Here, since the thickness direction of the substrate 40 coincides with the thickness direction DT of the current path portion 100, the accommodating chamber facing surface 548 faces the substrate 40 in the thickness direction DT. On the other hand, the thickness direction of the substrate 40 does not necessarily have to coincide with the thickness direction DT of the current path portion 100. The thickness direction of the substrate 40 may, for example, coincide with the longitudinal direction DL of the current path portion 100. In such case, the accommodating chamber facing surface 548 faces the substrate 40 in the longitudinal direction DL.

As shown in FIGS. 4, 17 and 18, the substrate recess 550 is recessed from the accommodating chamber facing surface 548 in the thickness direction DT. Further, the substrate recess 550 is formed at a position corresponding to the substrate notch 402. In such manner, the substrate recess 550 communicates with the substrate notch 402 in the thickness direction DT. Further, the number of substrate recesses 550 is the same as the number of substrate notches 402. Therefore, similarly to the substrate notch 402, it is preferable that a plane be formed by straight lines connecting the substrate recesses 550 with each other.

As shown in FIGS. 4, 17 and 19, the substrate protrusion 552 protrudes from the accommodating chamber facing surface 548 toward the substrate hole 404. Here, the substrate protrusion 552 protrudes from the accommodating chamber facing surface 548 in the thickness direction DT. In such manner, a portion of the substrate protrusion 552 is inserted into the substrate hole 404. The number of substrate protrusions 552 is the same as the number of substrate holes 404. Therefore, similarly to the substrate hole 404, it is preferable that a plane be formed by straight lines connecting the substrate protrusions 552 with each other.

The substrate protrusion 552 also includes a protrusion side face 5520 and a substrate flange 5522. The protrusion side face 5520 is a surface of the substrate protrusion 552 that extends in a direction in which the substrate protrusion 552 extends, i.e., a surface that extends in the thickness direction DT. The substrate flange 5522 extends from the protrusion side face 5520 in a direction perpendicular to the direction in which the substrate protrusion 552 extends, i.e., in a direction perpendicular to the thickness direction DT. Further, in the direction in which the substrate protrusion 552 extends, which is the thickness direction DT in this case, the substrate 40 is arranged at a position between the substrate flange 5522 and the accommodating chamber facing surface 548. Further, the substrate 40 and the substrate flange 5522 are in contact with each other by being thermally caulked or the like. In such manner, movement of the substrate 40 is restricted.

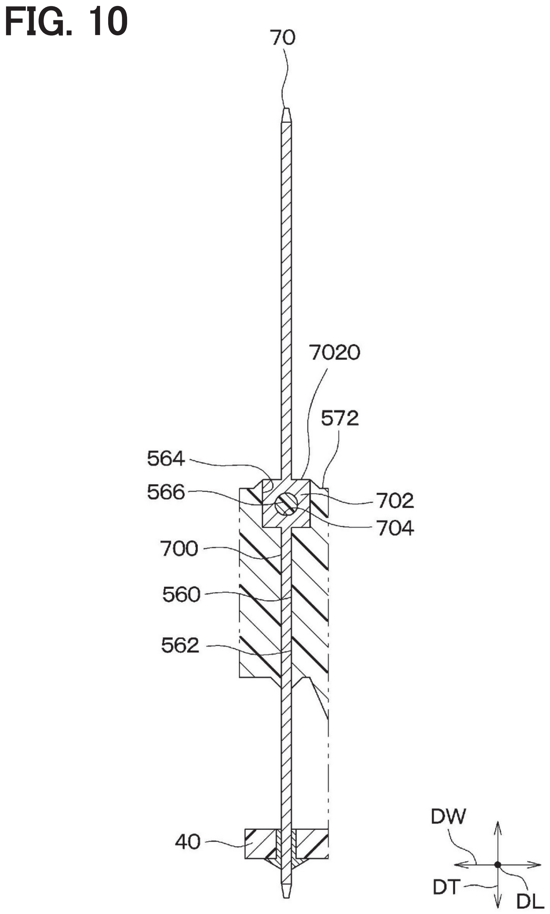

As shown in FIGS. 7 and 10, the terminal hole 560 is a space into which the terminal 70, which will be described later, is inserted.

The inner terminal surface 562 forms the terminal hole 560. Further, the terminal inner surface 562 faces a terminal side face 700 described later in a direction perpendicular to the direction in which the terminal 70 described later extends, which is a direction perpendicular to the thickness direction DT.

The terminal recess 564 is recessed in a direction in which a terminal flange 702 described later extends from the terminal inner surface 562, i.e., is recessed in the width direction DW. Further, the terminal recess 564 is in contact with the terminal flange 702, which will be described later. In such manner, the terminal recess 564 restricts movement of the terminal 70, which will be described later.

The terminal protrusion 566 protrudes from the terminal inner surface 562 in a direction in which a terminal hole 704 described later extends, i.e., protrudes in the longitudinal direction DL. Further, the terminal protrusion 566 is inserted into the terminal hole 704. In such manner, the terminal protrusion 566 is in contact with the terminal flange 702. Therefore, the terminal protrusion 566 restricts the movement of the terminal 70.

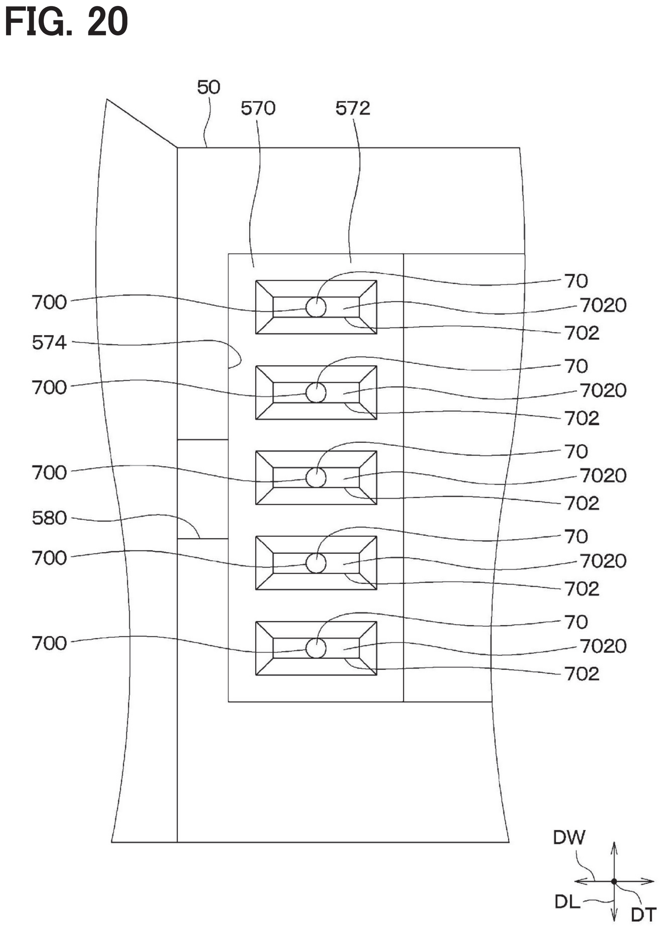

The liquid drain recess 570 accommodates a portion of the terminal 70 as shown in FIGS. 1, 5 and 20. As shown in FIG. 20, the liquid drain recess 570 includes a recess bottom surface 572 and a recess side face 574.

The recess bottom surface 572 is a surface perpendicular to the thickness direction DT and corresponds to a surface intersecting with the thickness direction DT. Further, the recess bottom surface 572 is positioned on one side of the case 50 opposite to the substrate 40. Further, a portion of the recess bottom surface 572 is formed in a step shape.

The recess side face 574 extends from the recess bottom surface 572 in the thickness direction DT. In such manner, the recess side face 574 and the recess bottom surface 572 form a space for the liquid drain recess 570.

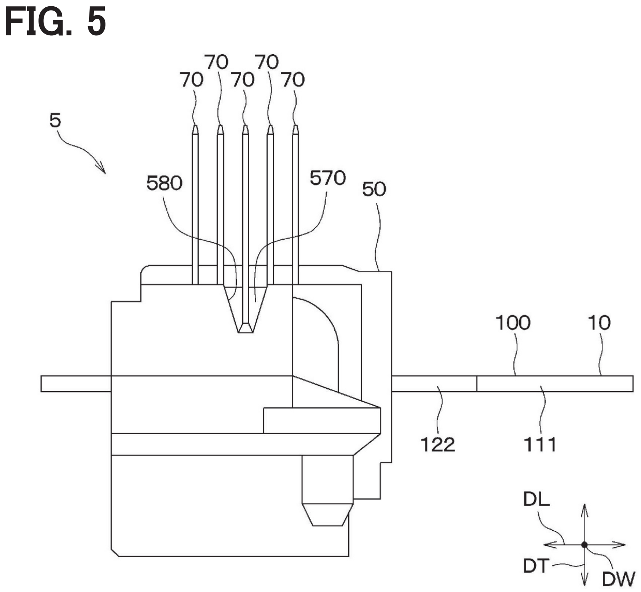

As shown in FIGS. 5 and 20, the liquid discharge portion 580 is a groove or a hole that communicates with the space of the liquid drain recess 570 and the outside of the case 50, i.e., penetrates the recess side face 574 in the width direction DW. Further, the liquid discharge portion 580 discharges liquid such as water that flows into the liquid drain recess 570 to the outside of the case 50. Although the liquid discharge portion 580 penetrates the recess side face 574 in the width direction DW, the configuration of the present disclosure is not limited to such configuration. The liquid discharge portion 580 may, for example, penetrate the recess side face 574 in the longitudinal direction DL.

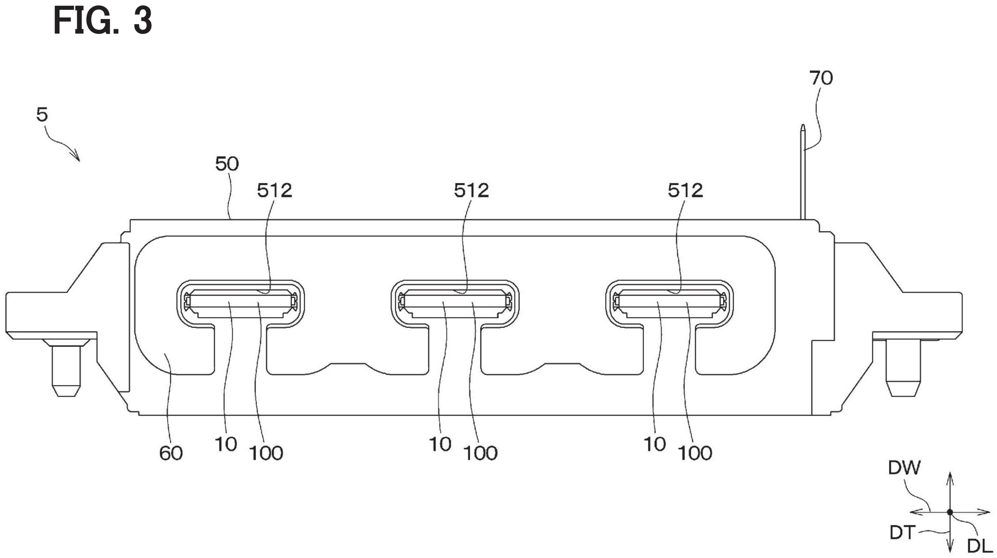

As shown in FIGS. 3, 7, 8 and 9, the resin filler 60 is formed at a position between an inner surface forming the core accommodating chamber 502 and a surface of the core 20 by filling of a resin such as urethane by insert molding or the like. Further, the resin filler 60 is formed at a position between the surface of the core 20 and a surface of the partition portion 504 facing the core 20 in the width direction DW. In such manner, the resin filler 60 covers the core 20, and fixes the core 20 and the case 50 in place.

Further, as shown in FIG. 9, the case protrusion 508 forms a space between the case facing surface 506 and a surface of the core 20 that faces the case facing surface 506 in the longitudinal direction DL. The resin filler 60 is formed in such space, and is therefore connected to the case facing surface 506 and to the surface of the core 20 that faces the case facing surface 506 in the longitudinal direction DL. In such manner, a contact area size between (a) the core 20 and the case 50 and (b) the resin filler 60 is increased, compared to a case where the case facing surface 506 and the core 20 are in contact or in adhesion with each other. Therefore, a force fixing the case 50 and the core 20 together is large.

Further, as shown in FIGS. 3 and 9, the resin filler 60 covers a core surface 27 and also covers the partition portion 504. In such manner, a size of the resin filler 60 covering the core 20 becomes larger than a case where the resin filler 60 does not cover the partition portion 504. In such manner, exposure of the core 20 to the outside is prevented. Note that the core surface 27 is a surface of the core 20 opposite to the case facing surface 506.

As shown in FIGS. 1 to 7, 10 and 20, a plurality of terminals 70 are formed. Further, the terminals 70 are arranged at intervals in the longitudinal direction DL. Further, the terminals 70 are arranged at intervals in a direction of the electric current flowing through the bus bar 10. As described later, the longitudinal direction DL and the direction of the electric current flowing through the bus bar 10 coincide with each other.

Further, as shown in FIGS. 7 and 10, a portion of the terminal 70 is inserted into a through hole in the substrate 40, and is connected to the substrate 40 by soldering or the like. In such manner, the terminal 70 is connected to the detection portion 30 via the lead wire 35. Therefore, the terminal 70 outputs a signal from the detection element 31 to an external device such as a computing device (not shown). Further, the terminal 70 is connected to components (not shown) arranged on the substrate 40.

Further, the terminal 70 extends from the substrate 40 in the thickness direction DT. Further, a portion of the terminal 70 is accommodated in the liquid drain recess 570 as shown in FIGS. 1 and 20. Further, the terminal 70 protrudes from a step portion of the recess bottom surface 572. In the present embodiment, since the thickness direction of the substrate 40 coincides with the thickness direction DT of the current path portion 100, the terminal 70 extends from the substrate 40 in the thickness direction DT. On the other hand, the thickness direction of the substrate 40 does not necessarily have to coincide with the thickness direction DT of the current path portion 100. The thickness direction of the substrate 40 may, for example, coincide with the longitudinal direction DL of the current path portion 100. In such case, the terminals 70 extend from the substrate 40 in the longitudinal direction DL.

Further, the terminal 70 includes the terminal side face 700, the terminal flange 702, and the terminal hole 704, as shown in FIG. 10.

The terminal side face 700 extends in a direction in which the terminal 70 extends, which is the thickness direction DT in this case. The terminal flange 702 extends from the terminal side face 700 in a direction perpendicular to the thickness direction DT, here in the width direction DW. Further, the terminal flange 702 and the terminal recess 564 are in contact with each other. In such manner, the movement of the terminal 70 is restricted. Further, the terminal 70 is formed symmetrically with respect to the terminal flange 702 in a direction in which the terminal 70 extends, which is the thickness direction DT in this case. Further, the terminal flange 702 includes an exposed portion 7020. The exposed portion 7020 is exposed from the terminal recess 564, and is therefore exposed to the outside.

The terminal hole 704 is a through hole or a bottomed hole that is surrounded by the terminal flange 702 and extends in a direction perpendicular to the direction in which the terminal flange 702 extends, i.e., extending in the longitudinal direction DL. The terminal protrusion 566 is inserted into the terminal hole 704. In such manner, the movement of the terminal 70 is restricted.

The current sensor 5 of the first embodiment is configured as described above. Next, current detection by the current sensor 5 will be described.

The current path portion 100 of the bus bar 10 extends in the longitudinal direction DL, and the current path portion 100 is connected to an inverter (not shown). Therefore, an alternating current from the inverter flows through the current path portion 100. At such time, the direction of the electric current flowing through the current path portion 100 is the longitudinal direction DL. Further, at such time, the alternating current flowing through the current path portion 100 generates a circumferential magnetic field centered on an axis that (a) passes through the current path portion 100 and (b) extends in the longitudinal direction DL. In such manner, the generated magnetic field causes magnetic field lines to pass through the core 20 and therefore through the gap 213. Therefore, the magnetic field lines pass through the detection element 31. Therefore, the detection element 31 detects the intensity of the magnetic field in the width direction DW. In such manner, the detection element 31 detects the alternating current from the inverter. Further, the detection element 31 outputs a signal corresponding to the intensity of the detected magnetic field via the lead wires 35, the substrate 40 and the terminal 70 to an external device such as a computing device (not shown) or the like. Then, the computing device calculates the alternating current from the inverter based on the signal from the detection element 31.

The current sensor 5 detects the electric current in an above-described manner. Next, how damage to the case 50 of the current sensor 5 is suppressed will be described.

Here, when a bus bar of the current sensor described in Patent Literature 1 is connected to a detection target by a bolt or the like, the bus bar is deformed. At such time, stress is applied to the bus bar, which in turn applies stress to a case that accommodates the bus bar. In such manner, the case may be damaged.

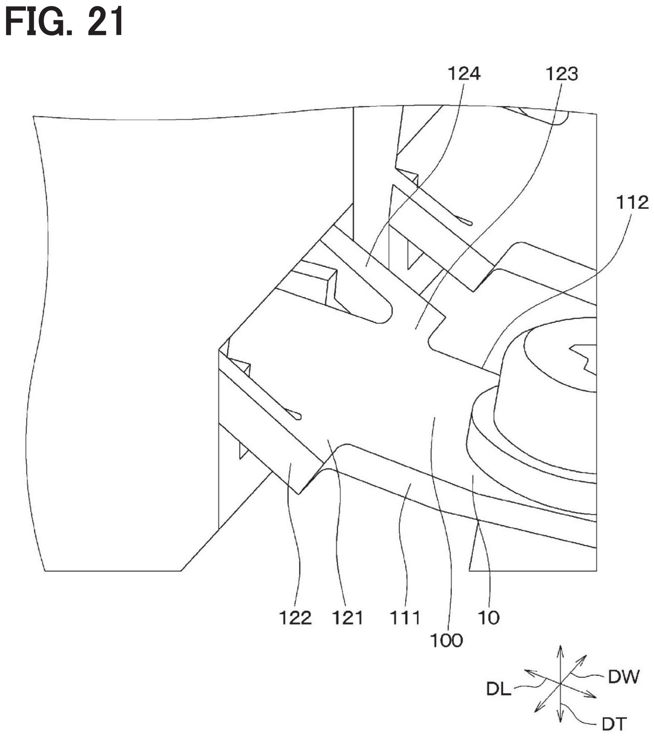

In contrast, in the current sensor 5 of the present embodiment, the bus bar 10 has a first side face 111, a first extension portion 121, a second extension portion 122, a second side face 112, a third extension portion 123, and a fourth extension portion 124, as shown in FIG. 11, and the like. The first side face 111 is a surface of the current path portion 100 that intersects with the width direction DW. The first extension portion 121 extends in the width direction DW from a region of a portion of the first side face 111 where the current path portion 100 protrudes from the case 50. The second extension portion 122 is connected to the first extension portion 121, and extends in a direction intersecting with the extending direction of the first extension portion 121. Further, when the current path portion 100 deforms in the thickness direction DT, the second extension portion 122 deforms in the thickness direction DT while coming into contact with the case 50. In such manner, when the current path portion 100 deforms in the thickness direction DT, the second extension portion 122 receives stress due to the force from the case 50 in addition to stress due to deformation of the current path portion 100. Therefore, when the current path portion 100 deforms in the thickness direction DT, the second extension portion 122 is more easily deformable in the thickness direction DT than the current path portion 100. Therefore, for example, as shown in FIG. 21, when the current path portion 100 deforms in the thickness direction DT, the second extension portion 122 deforms in the thickness direction DT by an amount greater than the deformation amount of the current path portion 100. Further, the second side face 112 is a surface that is positioned on the opposite side of the current path portion 100 to the first side face 111 and intersects with the width direction DW. The third extension portion 123 extends in the width direction DW from a region of a portion of the second side face 112 where the current path portion 100 protrudes from the case 50. The fourth extension portion 124 is connected to the third extension portion 123, and extends in a direction intersecting with a direction in which the third extension portion 123 extends. Further, when the current path portion 100 deforms in the thickness direction DT, the fourth extension portion 124 deforms in the thickness direction DT while coming into contact with the case 50. In such manner, when the current path portion 100 deforms in the thickness direction DT, the fourth extension portion 124 receives stress due to the force from the case 50 in addition to stress due to deformation of the current path portion 100. Therefore, when the current path portion 100 deforms in the thickness direction DT, the fourth extension portion 124 is more easily deformable in the thickness direction DT than the current path portion 100. Therefore, for example, when the current path portion 100 deforms in the thickness direction DT, the fourth extension portion 124 deforms in the thickness direction DT by an amount greater than the deformation amount of the current path portion 100.

Therefore, since the second extension portion 122 and the fourth extension portion 124 are easily deformable, thereby easily absorbing stress energy generated by the deformation of the bus bar 10 when connecting the bus bar 10 to a detection target such as an inverter or the like (not shown). In such manner, the stress applied to the case 50 that accommodates a part of the bus bar 10, the core 20, and the detection element 31 is reducible. Therefore, damage to the case 50 is suppressed.

Further, in the current sensor 5, effects described below are also achieved.

[1-1] The case 50 has the first inner surface 521, the first hole 531, the first protrusion 541, the second inner surface 522, the second hole 532, and the second protrusion 542. The first inner surface 521 forms the first hole 531. At least a portion of the second extension portion 122 is inserted into the space of the first hole 531. Further, the first inner surface 521 faces the second extension portion 122 in the width direction DW and the thickness direction DT. The first protrusion 541 protrudes from the first inner surface 521 toward the second extension portion 122, thereby contacting the second extension portion 122. The second inner surface 522 forms the second hole 532. At least a portion of the fourth extension portion 124 is inserted into the space of the second hole 532. Further, the second inner surface 522 faces the fourth extension portion 124 in the width direction DW and the thickness direction DT. The second protrusion 542 protrudes from the second inner surface 522 toward the fourth extension portion 124, thereby contacting the fourth extension portion 124.

In such manner, the positioning of the case 50 and the second extension portion 122 is performed, and also the positioning of the case 50 and the fourth extension portion 124 is performed. Therefore, the case 50 and the bus bar 10 are positioned. Therefore, variation in the relative position of the bus bar 10 with respect to the case 50 is reducible.

[1-2] The cross-sectional area of the second extension portion 122 when cut in a direction perpendicular to the longitudinal direction DL is smaller than the cross-sectional area of the current path portion 100 when cut in a direction perpendicular to the longitudinal direction DL. The length of the second extension portion 122 in the width direction DW is shorter than the length of the current path portion 100 in the width direction DW. Further, the cross-sectional area of the fourth extension portion 124 when cut in a direction perpendicular to the longitudinal direction DL is smaller than the cross-sectional area of the current path portion 100 when cut in a direction perpendicular to the longitudinal direction DL. The length of the fourth extension portion 124 in the width direction DW is shorter than the length of the current path portion 100 in the width direction DW.

In such manner, the second extension portion 122 and the fourth extension portion 124 are more easily deformable than the current path portion 100. Therefore, stress energy generated by deformation of the bus bar 10 when connecting the bus bar 10 to a detection target such as an inverter (not shown) is easily absorbable. In such manner, the stress applied to the case 50 that accommodates a part of the bus bar 10, the core 20, and the detection element 31 is reducible. Therefore, damage to the case 50 is suppressed.

[2-1] Here, the case of a current sensor such as the one described in Patent Literature 1 is subjected to stress due to (a) forces from outside the case, such as the force generated when connecting the bus bar to a detection target such as an inverter, and (b) heat generation due to the electric current flowing through the bus bar. Further, when a plurality of bus bars, cores, and sensor chips are accommodated in the case, the space inside the case needs to be large. Therefore, the rigidity of the case lowers. Thus, due to the stress applied to the case, the case is subject to deformation such as warpage or the like.

In contrast, in the current sensor 5 of the present embodiment, the case 50 has the core accommodating chamber 502 and the partition portion 504. The core accommodating chambers 502 correspond to a first accommodating chamber and a second accommodating chamber, and each accommodates two cores 20. The partitions 504 separate adjacent core accommodating chambers 502 from each other. Note that the bus bar 10 corresponds to a first bus bar and a second bus bar. Further, the core 20 corresponds to a first core and a second core. Further, the detection element 31 corresponds to a first detection element and a second detection element.

The partition portion 504 reinforces the core accommodating chamber 502. Therefore, the rigidity of the case 50 is improved compared to a case in which the partition portion 504 is not formed. Therefore, deformation such as warpage of the case 50 is suppressed.

[2-2] The current sensor 5 includes the resin filler 60. The resin filler 60 corresponds to a first resin portion and a second resin portion, and is formed of resin at a position between the inner surface that forms the core accommodating chamber 502 and the surface of the core 20. In such manner, the resin filler 60 is connected to the inner surface that forms the core accommodating chamber 502 and the surface of the core 20, and covers the core 20. Therefore, the core 20 and the case 50 are fixed.

Here, when the resin used for the resin filler 60 is urethane or the like, the material cost is relatively high. In contrast, in the current sensor 5 of the present embodiment, since the partition portion 504 is formed, the size of the resin filler 60 is smaller by the size of the partition portion 504, compared to when the partition portion 504 is not formed. Therefore, the amount of resin, such as urethane, used for filling is reducible, thereby reducing the cost of the current sensor 5.

[2-3] The case 50 has the case facing surface 506. The case facing surface 506 is one of the inner surfaces forming the core accommodating chamber 502 that faces the core 20 in the longitudinal direction DL. The core 20 has the core surface 27. The core surface 27 is a surface of the core 20 opposite to the case facing surface 506. The resin fillers 60 cover the core surface 27 and also cover the partition portions 504, thereby connecting the adjacent resin fillers 60 to each other. Note that the case facing surface 506 corresponds to a first facing surface and a second facing surface. The core surface 27 corresponds to a first core surface and a second core surface.

In such manner, the size of the resin filler 60 covering the core 20 becomes larger than when the resin filler 60 does not cover the partition portion 504. Therefore, exposure of the core 20 to the outside is suppressed.

[3-1] Here, when the force used to fix the case and core of the current sensor as described in Patent Literature 1 is weak, the position of the core relative to the case is likely to become misaligned. Further, when the position of the core is misaligned, the bus bars and the sensor chip will also be misaligned relative to the core. In such manner, the detection accuracy of the magnetic field intensity by the sensor chip deteriorates due to fluctuations in the magnetic field and changes in the detection position of the magnetic field intensity. Therefore, the current detection accuracy of the current sensor deteriorates.

In contrast, in the current sensor 5 of the present embodiment, the case 50 has the case facing surface 506 and the case protrusion 508. As described above, the case facing surface 506 is one of the inner surfaces forming the core accommodating chamber 502 that faces the core 20 in the longitudinal direction DL. The case protrusion 508 protrudes from the case facing surface 506 in the longitudinal direction DL, thereby forming a space between the case facing surface 506 and the surface of the core 20 that faces the case facing surface 506 in the longitudinal direction DL. The resin filler 60 is formed of resin at a position between the inner surface forming the core accommodating chamber 502 and the surface of the core 20, thereby (a) being connected to the inner surface forming the core accommodating chamber 502 and to the surface of the core 20 and (b) covering the core 20. Further, the resin filler 60 is formed at a position between the case facing surface 506 and the surface of the core 20 facing the case facing surface 506 in the longitudinal direction DL. In such manner, the resin filler 60 is connected to (a) the case facing surface 506 and (b) the surface of the core 20 that faces the case facing surface 506 in the longitudinal direction DL.

By forming the case protrusion 508, a space is formed at a position between the case facing surface 506 and the surface of the core 20 that faces the case facing surface 506 in the longitudinal direction DL. Since the resin filler 60 is formed in such space, a contact area size between (a) the core 20 and the case 50 and (b) the resin filler 60 is increased, compared to a case where the case facing surface 506 and the core 20 are in contact or in adhesion with each other. In such manner, the force with which the resin filler 60 fixes the core 20 and the case 50 together increases. Therefore, misalignment of the core 20 relative to the case 50 is suppressed, thereby suppressing misalignment of the bus bar 10 and the detection element 31 relative to the core 20. Thus, deterioration of the detection accuracy for detecting the intensity of the magnetic field by the detection element 31 is suppressed. Thus, the deterioration of the current detection accuracy is suppressed.

[3-2] The case protrusion 508 is in contact with the core 20. In such manner, positioning of the case 50 and the core 20 is made easy.
[3-3] Three or more case protrusions 508 are formed. Further, a plane is formed by the straight lines connecting the case protrusions 508 with each other.

In such manner, supporting the core 20 by the case protrusions 508 is made easy, compared to when the number of case protrusions 508 is one or two. Therefore, misalignment of the core 20 with respect to the case 50 is suppressed.

[4-1] Here, as described above, when misalignment of the core with respect to the case is caused in the current sensor described in Patent Literature 1, the positioning of the bus bar and the sensor chip with respect to the core is also misaligned. In such manner, the detection accuracy of the magnetic field intensity by the sensor chip deteriorates due to fluctuations in the magnetic field and changes in the detection position of the magnetic field intensity. Therefore, the current detection accuracy of the current sensor deteriorates.

In contrast, in the current sensor 5 of the present embodiment, the case 50 has the case protrusion 508. The case protrusion 508 protrudes from the inner surface that forms the core accommodating chamber 502 toward the core 20, thereby coming into contact with the core 20. Here, the case protrusion 508 protrudes from the case facing surface 506 in the longitudinal direction DL, thereby coming into contact with the core 20 in the longitudinal direction DL.

In such manner, positioning of the case 50 and the core 20 is made easy. Therefore, misalignment of the core 20 relative to the case 50 is suppressed, thereby suppressing misalignment of the bus bar 10 and the detection element 31 relative to the core 20. Thus, deterioration of the detection accuracy for detecting the intensity of the magnetic field by the detection element 31 is suppressed. Thus, the deterioration of the current detection accuracy is suppressed.

[5-1] When an electric current flows through a bus bar of a current sensor such as the one described in Patent Literature 1, the bus bar generates heat. There is a risk that the case 50 will be damaged due to heat generated by the bus bar.

In contrast, in the current sensor 5 of the present embodiment, the case 50 has the opening 512. The opening 512 is inserted into the core hole 24, and has the bus bar 10 inserted therein. Further, the bus bar 10 has the first bus bar protrusion 131 and the second bus bar protrusion 132. The first bus bar protrusion 131 protrudes from the first side face 111 toward the opening 512, and is thereby in contact with the opening 512. The second bus bar protrusion 132 protrudes from the second side face 112 toward the opening 512, and is thereby in contact with the opening 512. Further, a space is formed at a position between the opening 512 and the first bus bar protrusion 131 and the second bus bar protrusion 132. It should be noted that the first side face 111 and the second side face 112 correspond to surfaces facing the opening portion 512.

In such manner, heat generated by the bus bar 10 is not easily transmittable to the case 50. Therefore, damage to the case 50 is suppressed. Further, heat is not easily transmittable from the case 50 to the detection element 31. Therefore, transmission of heat to the detection element 31 is suppressed. Therefore, changes in the characteristics and failures of the detection element 31 are suppressed.

[5-2] The first bus bar protrusion 131 includes the first contact portion 1310 and the first inclined portion 1311. The first contact portion 1310 is in contact with the opening 512. The first inclined portion 1311 is connected to the first contact portion 1310 and is inclined in a direction such that the size of the first bus bar protrusion 131 decreases with increasing distance from a boundary with the first contact portion 1310. Further, the second bus bar protrusion 132 also includes the second contact portion 1320 and the second inclined portion 1321. The second contact portion 1320 is in contact with the opening 512. The second inclined portion 1321 is connected to the second contact portion 1320 and is inclined in a direction such that the size of the second bus bar protrusion 132 decreases with increasing distance from a boundary with the second contact portion 1320.

In such manner, when the bus bar 10 is inserted into the space of the opening 512, the bus bar 10 is guided by the first inclined portion 1311 and the second inclined portion 1321. In such manner, insertion of the bus bar 10 into the space of the opening 512 is made easy. Also in such manner, wear caused by contact between (a) the first bus bar protrusions 131 and the second bus bar protrusions 132 and (b) the openings 512 is suppressed. Therefore, abrasion powder caused by contact between (a) the first bus bar protrusions 131 and the second bus bar protrusions 132 and (b) the openings 512 is suppressed from entering the fastening portion 102. Therefore, when connecting the fastening portion 102 to a detection target such as an inverter (not shown), damage to the bus bar 10 caused by abrasion powder getting caught in the fastening portion 102 is suppressed.

[5-3] The opening 512 includes the opening face 5120 and the opening protrusion 5122. The opening face 5120 faces the bus bar 10. The opening protrusion 5122 protrudes from the opening face 5120 toward the first bus bar protrusion 131 and the second bus bar protrusion 132, thereby coming into contact with the first bus bar protrusion 131 and the second bus bar protrusion 132.

In such manner, positioning of the case 50 and the bus bar 10 is made easy. Further, compared to a case where the opening protrusion 5122 is not provided, the size of the space between the opening 512 and the first bus bar protrusion 131 and the second bus bar protrusion 132 becomes larger. Therefore, heat generated by the bus bar 10 is not easily transmitted to the case 50. Therefore, heat is not easily transmitted from the case 50 to the detection element 31. Thus, the transmission of heat to the detection element 31 is suppressed, thereby suppressing changes in the characteristics and failure of the detection element 31.

[5-4] The Young's modulus of the opening protrusion 5122 is smaller than the Young's modulus of the first bus bar protrusion 131 and the second bus bar protrusion 132.

In such manner, the opening protrusion 5122 is more easily deformable than the first bus bar protrusion 131 and the second bus bar protrusion 132, thereby easily absorbing stress energy generated by deformation of the bus bar 10 when connecting the bus bar 10 to a detection target such as an inverter (not shown). Therefore, the stress applied to the case 50 that accommodates a part of the bus bar 10, the core 20, and the detection element 31 is reducible. Therefore, damage to the case 50 is suppressed.

[5-5] The opening protrusion 5122 includes the protrusion contact portion 5124 and the protrusion inclined portion 5126. The protrusion contact portion 5124 is in contact with the first bus bar protrusion 131 and the second bus bar protrusion 132. The protrusion inclined portion 5126 is connected to the protrusion contact portion 5124, and is inclined in a direction such that the size of the opening protrusion 5122 decreases with increasing distance from the boundary with the protrusion contact portion 5124.

In such manner, when the bus bar 10 is inserted into the space of the opening 512, the bus bar 10 is guided by the protrusion inclined portion 5126. In such manner, insertion of the bus bar 10 into the space of the opening 512 is made easy. In such manner, similarly to the above, abrasion caused by contact between the first bus bar protrusion 131 and the second bus bar protrusion 132 and the opening 512 is suppressed.

[6-1] Here, in a current sensor such as the one described in Patent Literature 1, a printed circuit board to which a sensor chip is connected may be accommodated in a case. In such case, when the position of the printed circuit board is misaligned with respect to the case, the position of the sensor chip is also misaligned with respect to the case. Further, when the position of the sensor chip is misaligned, the positions of the core and the bus bars relative to the sensor chip are also misaligned. In such manner, the detection accuracy of the magnetic field intensity by the sensor chip deteriorates due to fluctuations in the magnetic field and changes in the detection position of the magnetic field intensity. Therefore, the current detection accuracy of the current sensor deteriorates.

In contrast, in the current sensor 5 of the present embodiment, the substrate 40 has the substrate side face 400 and the substrate notch 402. The substrate notch 402 is recessed from the substrate side face 400. Further, the case 50 has the substrate accommodating chamber 510, the accommodating chamber facing surface 548, and the substrate recess 550. The substrate accommodating chamber 510 accommodates the substrate 40. The accommodating chamber facing surface 548 is a surface that forms the substrate accommodating chamber 510, and faces the substrate 40. The substrate recess 550 corresponds to a case recess, and is recessed from the accommodating chamber facing surface 548. Further, the substrate recess 550 is formed at a position corresponding to the substrate notch 402, thereby in communication with the substrate notch 402.

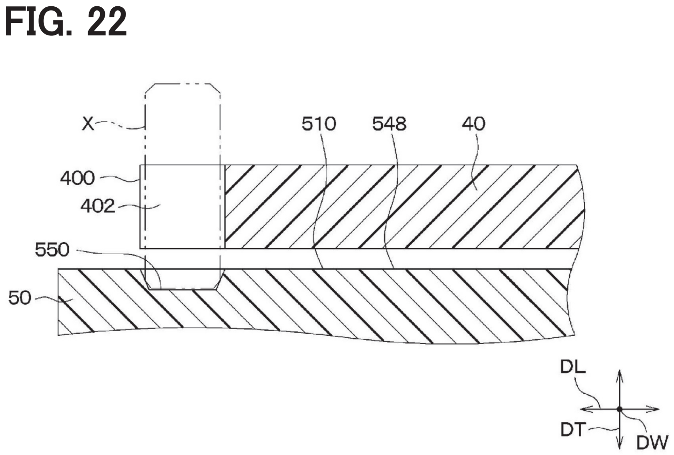

In such manner, the substrate notch 402 and the substrate recess 550 are usable as markers, thereby making it easier to position the substrate 40 and the case 50, compared to a case in which the substrate notch 402 and the substrate recess 550 are not formed. For example, as shown in FIG. 22, by fitting a jig X such as a pin into the substrate recess 550 and having such jig X to guide the substrate notch 402, it becomes easier to attach the substrate 40 and the case 50 and also easier to position the substrate 40 and the case 50. Therefore, the misalignment of the substrate 40 with respect to the case 50 is suppressed. Therefore, the misalignment of the detection element 31 with respect to the case 50 is suppressed. Thus, misalignment of the core 20 and the bus bar 10 relative to the detection element 31 is suppressed. In such manner, deterioration in the detection accuracy of the magnetic field intensity by the detection element 31 is suppressed. Therefore, deterioration of the current detection accuracy is suppressed.

[6-2] Three or more substrate notches 402 and substrate recesses 550 are formed. Further, a plane is formed by the straight lines connecting the substrate notches 402 with each other, and a plane is formed by the straight lines connecting the substrate recesses 550 with each other.

In such manner, the positions of the substrate notch 402 and the substrate recess 550 are uniquely determined. Therefore, positioning of the substrate notch 402 and the substrate recess 550 is made easy, compared to when the number of the substrate notch 402 and the substrate recess 550 is one or two. Therefore, misalignment of the substrate 40 with respect to the case 50 is suppressed.

[7-1] As described above, in the current sensor as described in Patent Literature 1, a printed circuit board to which a sensor chip is connected may be accommodated in a case. In such case, when the position of the printed circuit board is misaligned with respect to the case, the position of the sensor chip is also misaligned with respect to the case. Further, when the position of the sensor chip is misaligned, the positions of the core and the bus bars relative to the sensor chip are also misaligned. In such manner, the detection accuracy of the magnetic field intensity by the sensor chip deteriorates due to fluctuations in the magnetic field and changes in the detection position of the magnetic field intensity. Therefore, the current detection accuracy of the current sensor deteriorates.

In contrast, in the current sensor 5 of the present embodiment, the substrate 40 has the substrate hole 404. The substrate hole 404 penetrates the inside of the substrate 40. The case 50 has the substrate accommodating chamber 510, the accommodating chamber facing surface 548, and the substrate protrusion 552. As described above, the substrate accommodating chamber 510 accommodates the substrate 40. As described above, the accommodating chamber facing surface 548 is a surface that forms the substrate accommodating chamber 510 and faces the substrate 40. The substrate protrusion 552 corresponds to a case protrusion, protrudes from the accommodating chamber facing surface 548 toward the substrate hole 404, and is inserted into the substrate hole 404. The substrate protrusion 552 includes the protrusion side face 5520 and the substrate flange 5522. The protrusion side face 5520 extends in a direction in which the substrate protrusion 552 extends, which is the thickness direction DT here. The substrate flange 5522 corresponds to a case flange, and extends from the protrusion side face 5520 in a direction perpendicular to the direction in which the substrate protrusion 552 extends, i.e., in a direction perpendicular to the thickness direction DT. Further, in a direction in which the substrate protrusion 552 extends, i.e., in the thickness direction DT, the substrate 40 is positioned between the substrate flange 5522 and the accommodating chamber facing surface 548, and the substrate 40 and the substrate flange 5522 are in contact with each other, thereby restricting movement of the substrate 40.

In such manner, misalignment of the substrate 40 with respect to the case 50 is suppressed. Therefore, misalignment of the detection element 31 with respect to the case 50 is suppressed. Thus, misalignment of the core 20 and the bus bar 10 relative to the detection element 31 is suppressed. In such manner, deterioration of the detection accuracy of the magnetic field intensity by the detection element 31 is prevented. Therefore, deterioration in the current detection accuracy is prevented.

[7-2] Three or more substrate holes 404 and substrate flanges 5522 are formed. Further, a plane is formed by the straight lines connecting the substrate holes 404 with each other, and a plane is also formed by the straight lines connecting the substrate flanges 5522 with each other.

In such manner, the substrate hole 404 and the substrate flange 5522 are more easily supportable with each other, compared to when the number of substrate holes 404 and substrate flanges 5522 is one or two. Therefore, the misalignment of the substrate 40 with respect to the case 50 is suppressed.

[8-1] Here, the case of a current sensor such as the one described in Patent Literature 1 is subjected to stress due to forces from outside the case, such as the force generated when connecting the bus bar to a detection target such as an inverter, and heat generation due to an electric current flowing through the bus bar. Further, since the two bus bars are arranged side by side in the width direction, the length of the case in the width direction is longer than the length of the case in the longitudinal direction. At such time, therefore, the amount of warpage, for example, the amount of bending, of the case in the width direction becomes greater than the amount of warpage of the case in the longitudinal direction. Further, in the current sensor described in Patent Literature 1, a plurality of connection terminals are arranged at intervals in the width direction. In such case, the amount of warpage of the case in the width direction is large, and therefore the amount of change in the interval between the connection terminals due to stress applied to the case increases. Therefore, due to the connection terminal easily misaligned, connecting the connection terminal to an external device becomes difficult. Therefore, connection failures between the connection terminals and external devices may be easily caused.

In contrast, in the current sensor 5 of the present embodiment, the length of the case 50 in the width direction DW is longer than the length of the case 50 in the longitudinal direction DL, and the multiple terminals 70 are arranged at intervals in the longitudinal direction DL.

When stress is applied to the case 50, the amount of warpage of the case 50 in the longitudinal direction DL is smaller than the amount of warpage of the case 50 in the width direction DW. Therefore, the amount of change in the interval between the terminals 70 caused by stress being applied to the case 50 is reducible, compared to when multiple terminals 70 are arranged at intervals in the width direction DW. Therefore, misalignment of the terminal 70 is suppressed. In such manner, connecting the terminal 70 to an external device is made easy. Therefore, connection failures between the terminal 70 and the external device are suppressed.

[8-2] The terminal 70 extends in the thickness direction DT from the substrate 40, thereby protruding from the recess bottom surface 572 that corresponds to the outer surface of the case 50 opposite to the substrate 40.

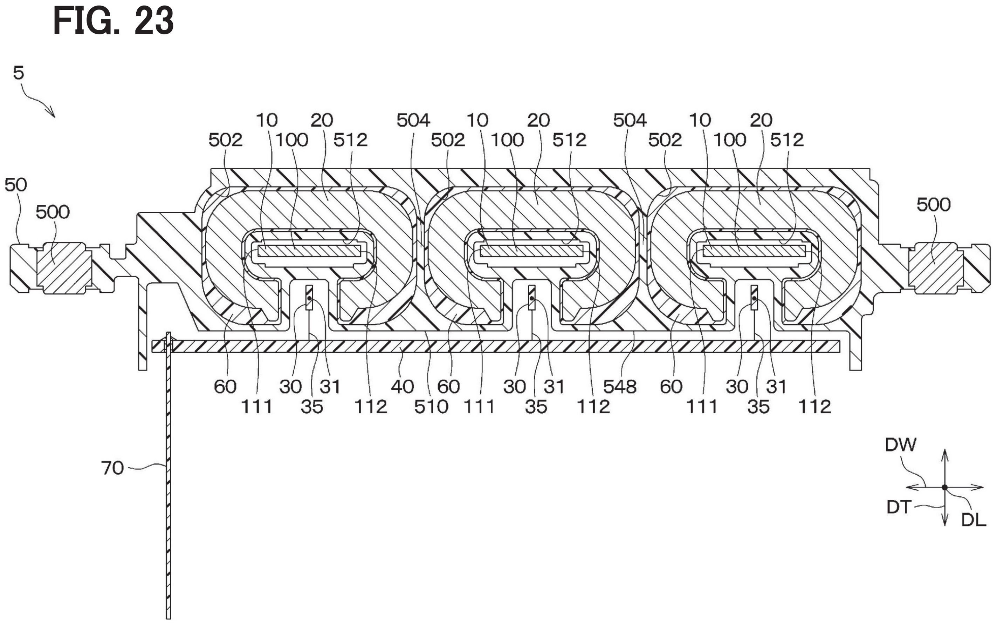

In such manner, when the length of the terminal 70 in the thickness direction DT is fixed, the size of the current sensor 5 is smaller than when the terminal 70 extends from the substrate 40 on an opposite side of the case 50, which is shown in FIG. 23 Therefore, increase of the size of the current sensor 5 is suppressed.

[8-3] A plurality of terminals 70 are arranged at intervals in the longitudinal direction DL, and the length of the substrate 40 in the width direction DW is longer than the length of the substrate 40 in the longitudinal direction DL.

In such manner, it becomes easier for the wiring on the substrate 40 connected to the terminals 70 to extend in the width direction DW, thereby preventing detours, compared to when multiple terminals 70 are arranged at intervals in the width direction DW. Therefore, complication of the wiring layout of the substrate 40 is suppressed. Thus, the interval between adjacent wirings on the substrate 40 is suppressed from becoming smaller. Thus, the wiring on the substrate 40 is prevented from becoming a source of electromagnetic interference with each other, and also is prevented from suffering from electromagnetic interference. Thus, the lack of EMC of the current sensor 5 is suppressed. It should be noted that EMC is an abbreviation for Electro Magnetic Compatibility, and means electromagnetic compatibility.

[9-1] Here, in a current sensor such as the one described in Patent Literature 1, a magnetic field generated by an electric current flowing through the bus bar passes through the connection terminal. Further, the connection terminals are arranged at intervals in a direction perpendicular to the direction of the electric current flowing through the bus bar. Further, the intensity of the magnetic field generated by the electric current flowing through the bus bar differs depending on the position in the direction perpendicular to the direction of the electric current flowing through the bus bar. Therefore, each connection terminal is affected by a magnetic field of different intensity, and the accuracy of the signal output from the connection terminal decreases.

In contrast, in the current sensor 5 of the present embodiment, the multiple terminals 70 are arranged at intervals in the direction of the electric current flowing through the bus bar 10, i.e., in the longitudinal direction DL.

Here, when the position in the direction perpendicular to the direction of the electric current flowing through the bus bar 10 and the value of the electric current flowing through the bus bar 10 are fixed, the intensity of the magnetic field generated by the electric current flowing through the bus bar 10 tends to be the same, even when the position in the direction of the electric current flowing through the bus bar 10 is different. Therefore, by arranging the multiple terminals 70 at intervals in the direction of the electric current flowing through the bus bar 10, the intensity of the magnetic field affecting each terminal 70 tends to be the same. Therefore, since each terminal 70 is susceptible to the influence of magnetic fields of the same intensity, the deterioration in accuracy of the signal output from the terminal 70 is suppressed, compared to a case in which each terminal 70 is influenced by magnetic fields of different intensities.

[10-1] Here, in the current sensor described in Patent Literature 1, the connection terminals protrude from the case. When the connection terminal falls off from the sensor chip or the case, the signal from the sensor chip will no longer be output to the external device.

In contrast, in the current sensor 5 of the present embodiment, the terminal 70 includes the terminal side face 700 and the terminal flange 702. The terminal side face 700 extends in a direction in which the terminal 70 extends, which is the thickness direction DT in this case. The terminal flange 702 extends from the terminal side face 700 in a direction perpendicular to the direction in which the terminal 70 extends, i.e., extends in the width direction DW. Further, the case 50 has the terminal hole 560, the terminal inner surface 562, and the terminal recess 564. The terminal hole 560 corresponds to a case hole, and the terminal 70 is inserted into the terminal hole 560. The terminal inner surface 562 corresponds to a case inner surface, forms the terminal hole 560, and faces the terminal side face 700 in a direction perpendicular to the direction in which the terminal 70 extends, i.e., extends in the width direction DW. The terminal recess 564 corresponds to a case recess, and is recessed in a direction in which the terminal flange 702 extends from the terminal inner surface 562, that is, i.e., extends in the width direction DW. Further, the terminal recess 564 is in contact with the terminal flange 702, thereby restricting the movement of the terminal 70.

In such manner, the movement of the terminal 70 is restricted, thereby suppressing the terminal 70 from coming off from the substrate 40 or the case 50. Therefore, the signal from the detection element 31 is prevented from being no longer output to the external device.

[10-2] Here, the terminal 70 is relatively thin. Therefore, when molding the case 50 by injection molding or the like and assembling the terminal 70 and the case 50 together, it is relatively difficult to hold down the mold used for injection molding, i.e., it is relatively difficult for appropriately positioning the mold relative to the terminal 70. Further, bending the terminal 70 or the like is relatively difficult. Therefore, assembling the terminal 70 and the case 50 is relatively difficult.

In contrast, in the current sensor 5 of the present embodiment, the terminal flange 702 includes the exposed portion 7020. The exposed portion 7020 is exposed from the terminal recess 564, and is therefore exposed to the outside.

In such manner, the exposed portion 7020 is used as a pressing position for a mold that is used for injection molding, when molding the case 50 by injection molding or the like and assembling the terminal 70 and the case 50 together. Further, since the terminal flange 702 extends from the terminal side face 700, the exposed portion 7020 is larger than in case where the terminal flange 702 is not formed. Thus, it becomes easier to hold down the mold used for injection molding. Therefore, it becomes easier to mold the case 50 by injection molding or the like, and to assemble the terminal 70 and the case 50 together.

[10-3] The terminal 70 is formed symmetrically with respect to the direction in which the terminal 70 extends, that is, i.e., the thickness direction DT, with the terminal flange 702 as the center. The symmetry includes the manufacturing error range.

In such manner, the terminal 70 and the case 50 is prevented from being assembled in an incorrect orientation with respect to the case 50. Further, the process of assembling the terminal 70 and the case 50 can be easily controlled, and the number of steps required for process control is reducible.

[10-4] The terminal 70 has the terminal hole 704. The terminal hole 704 is surrounded by the terminal flange 702, and extends in a direction perpendicular to the direction in which the terminal flange 702 extends, that is, i.e., extends in the longitudinal direction DL. Further, the case 50 has the terminal protrusion 566. The terminal protrusion 566 corresponds to an insertion portion, and protrudes from the terminal inner surface 562 in the direction in which the terminal hole 704 extends, i.e., in the longitudinal direction DL, and is inserted into the terminal hole 704. Further, the terminal protrusion 566 is in contact with the terminal flange 702, thereby restricting the movement of the terminal 70.

In such manner, the movement of the terminal 70 is restricted, thereby preventing the terminal 70 from coming off from the substrate 40 or the case 50.

[11-1] Here, when liquid such as water generated by condensation due to the usage environment of the current sensor remains on the connection terminal of the current sensor as described in Patent Literature 1, the connection terminal corrodes. When the connection terminal corrodes, separation occurs between the connection terminal and the case, starting from the corroded portion of the connection terminal, and a crack occurs in the case, starting from the separated portion.

In contrast, in the current sensor 5 of the present embodiment, the case 50 has the liquid drain recess 570 and the liquid discharge portion 580. The liquid drain recess 570 corresponds to an accommodation recess and a case recess, and accommodates a part of the terminal 70. The liquid discharge portion 580 communicates with the space of the liquid drain recess 570 and the outside of the case 50, thereby discharging liquid such as water that flows into the liquid drain recess 570 to the outside of the case 50.

In such manner, liquid such as water that flows into the liquid drain recess 570 is prevented from remaining in the terminal 70. Therefore, corrosion of the terminal 70 is suppressed. Therefore, separation between the terminal 70 and the case 50 is suppressed. Therefore, the occurrence of cracks in the case 50 is suppressed.

[11-2] The liquid drain recess 570 includes the recess bottom surface 572 and the recess side face 574. The recess bottom surface 572 intersects with the thickness direction DT. The recess side face 574 extends from the recess bottom surface 572 in the thickness direction DT, thereby forming a space of the liquid drain recess 570 together with the recess bottom surface 572. Further, the length of the case 50 in the width direction DW is longer than the length of the case 50 in the longitudinal direction DL. Further, the liquid discharge portion 580 penetrates the recess side face 574 in the width direction DW.

Here, since the length of the case 50 in the longitudinal direction DL is shorter than the length of the case 50 in the width direction DW, when stress is applied to the case 50, the amount of warpage of the case 50 in the longitudinal direction DL is smaller than the amount of warpage of the case 50 in the width direction DW. Therefore, stress acting on the liquid discharge portion 580 penetrating the recess side face 574 in the width direction DW is smaller than stress acting on the liquid discharge portion 580 penetrating the recess side face 574 in the longitudinal direction DL. Therefore, damage to the liquid discharge portion 580 is suppressed.

[11-3] Here, when the case 50 is made of resin and liquid such as water remains in the case 50, hydrolysis occurs, causing deterioration of the case 50.

In contrast, in the current sensor 5 of the present embodiment, the liquid discharge portion 580 discharges liquid such as water that flows into the liquid drain recess 570 to the outside of the case 50, and the case 50 is made of resin.

In such manner, liquid such as water is prevented from remaining in the case 50. Therefore, the occurrence of hydrolysis is suppressed. Therefore, deterioration of the case 50 is suppressed.

### (Second Embodiment)

In the second embodiment, the configurations of the second extension portion 122 and the fourth extension portion 124 are different from those in the first embodiment. The other configurations are the same as those of the first embodiment.

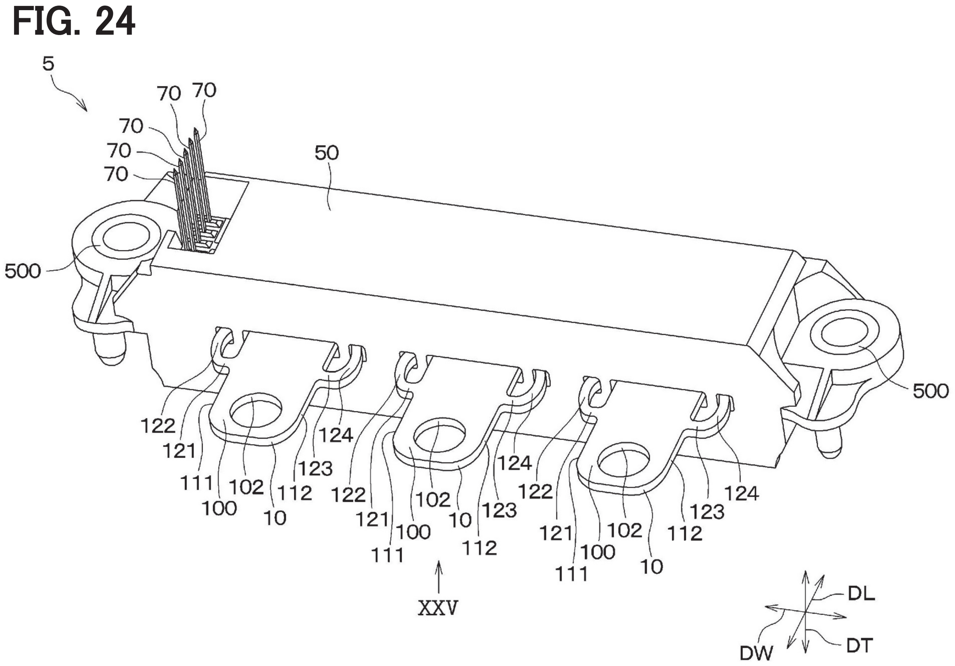

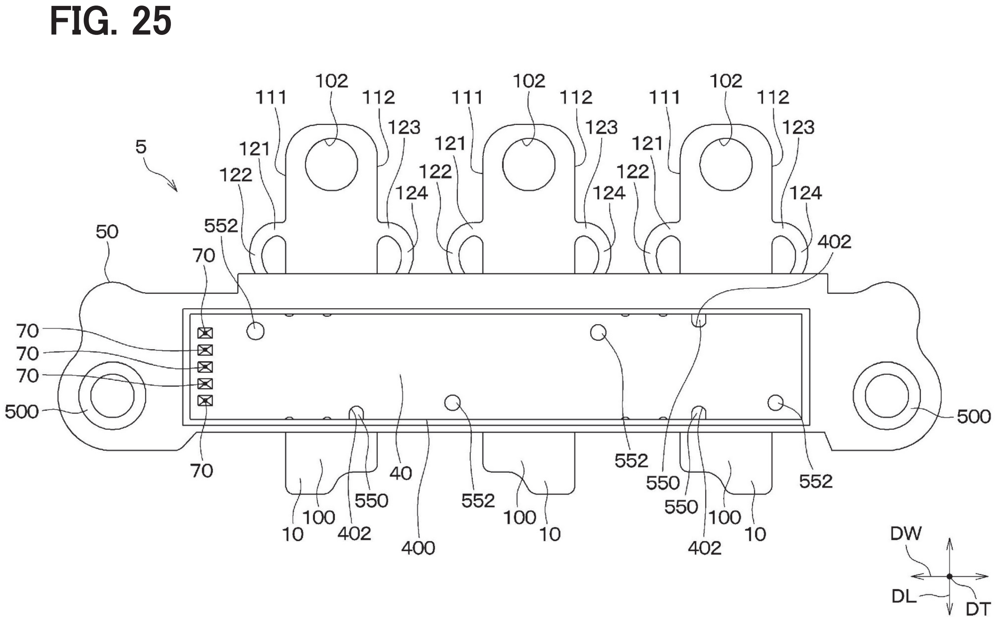

Specifically, as shown in FIGS. 24 and 25, the second extension portion 122 and the fourth extension portion 124 are formed in an arc shape instead of being formed in a linear shape.

The current sensor 5 of the second embodiment is configured as described above. The current sensor 5 of the second embodiment achieves similar effects achieved by the first embodiment.

### (Third Embodiment)

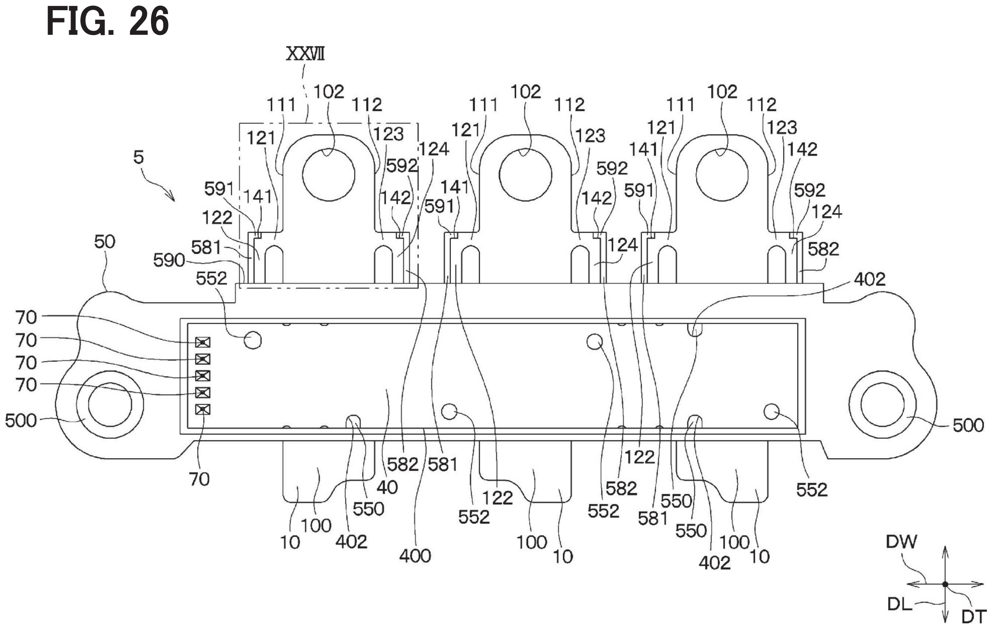

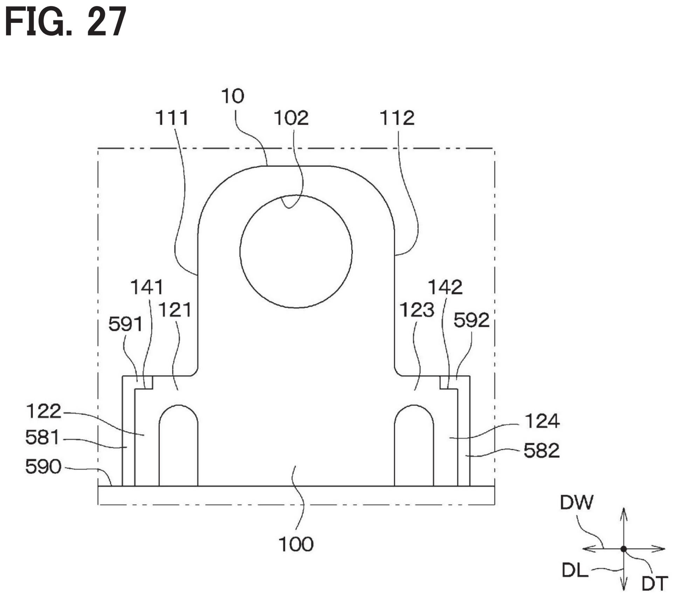

In the third embodiment, as shown in FIGS. 26 and 27, the shape of the case 50 is different from that in the first embodiment. Further, the shapes of the second extension portion 122 and the fourth extension portion 124 are different from those in the first embodiment. The other configurations are similar to those of the first embodiment.

The case 50 further includes a bus bar insertion side case outer surface 590, a first case extension portion 581, a first claw portion 591, a second case extension portion 582, and a second claw portion 592.

The bus bar insertion side case outer surface 590 is an outer surface of the case 50 facing in the longitudinal direction DL. Further, the bus bar insertion side case outer surface 590 is a surface of the case 50 that is perpendicular to the longitudinal direction DL, and corresponds to a surface of the case 50 that intersects with the longitudinal direction DL.

The first case extension portion 581, the first claw portion 591, the second case extension portion 582, and the second claw portion 592 are configured as a snap fit.

Specifically, the first case extension portion 581 extends from within the bus bar insertion side case outer surface 590 in the longitudinal direction DL. Here, the first case extension portion 581 is positioned outside of the second extension portion 122 in the width direction DW.

The first claw portion 591 is connected to one side of the first case extension portion 581 opposite to the bus bar insertion side case outer surface 590. Further, the first claw portion 591 extends from the first case extension portion 581 in a direction intersecting with the direction in which the first case extension portion 581 extends. Here, the first claw portion 591 extends from the first case extension portion 581 in the width direction DW.

The second case extension portion 582 extends from within the bus bar insertion side case outer surface 590 in the longitudinal direction DL. Here, the second case extension portion 582 is positioned outside of the fourth extension portion 124 in the width direction DW.

The second claw portion 592 is connected to the second case extension portion 582 on the opposite side to the bus bar insertion side case outer surface 590. Further, the second claw portion 592 extends from the second case extension portion 582 in a direction intersecting with the direction in which the second case extension portion 582 extends. Here, the second claw portion 592 extends from the second case extension portion 582 in the width direction DW.

The second extension portion 122 further includes a first claw recess 141. The first claw recess 141 is formed in a shape corresponding to the first claw portion 591.

The fourth extension portion 124 further includes a second claw recess 142. The second claw recess 142 is formed in a shape corresponding to the second claw portion 592.

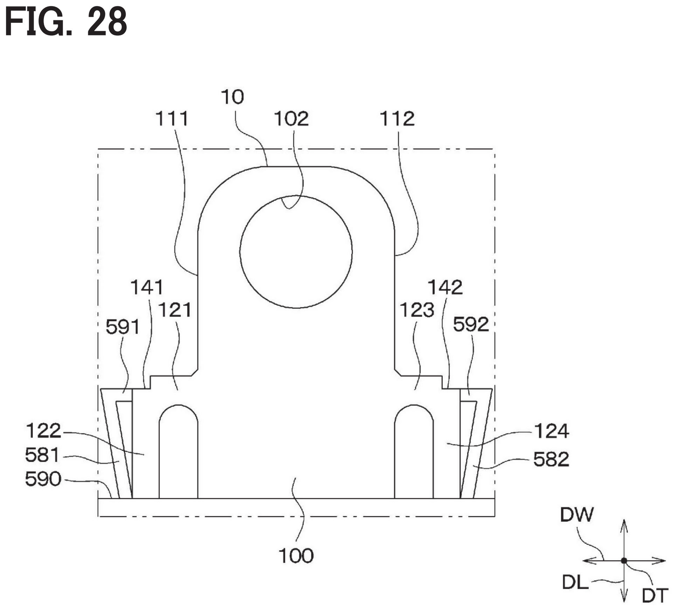

Here, as shown in FIG. 28, when bus bar 10 is inserted into the case 50, the first case extension portion 581 and the second case extension portion 582 are elastically deformed. Further, when the bus bar 10 and the case 50 are brought closer to each other, as shown in FIG. 27, the first claw portion 591 comes into contact with the first claw recess 141, and the second claw portion 592 comes into contact with the second claw recess 142. In such manner, movement of the bus bar 10 in the longitudinal direction DL and the width direction DW is restricted.

The current sensor 5 of the third embodiment is configured as described above. The current sensor 5 of the third embodiment achieves similar effects achieved by the first embodiment. Further, the third embodiment also achieves the effects described below.

[12-1] Here, when connecting the bus bar of a current sensor as described in Patent Literature 1 to a detection target using a bolt or the like, when the position of the bus bar is misaligned with respect to the case, it becomes difficult to connect the bus bar to the detection target. Further, when the case and the bus bar are fixed to each other by means of screws or the like, the fixing force exerts stress on the case. Therefore, when connecting the bus bar to the detection target, the stress caused by the fixing force is added to the stress caused when connecting the bus bar to the detection target, resulting in a large stress on the case. Therefore, when the case and the bus bar are fixed by screws or the like, the case is easily damaged.

In contrast, in the current sensor 5 of the third embodiment, the case 50 further includes the bus bar insertion side case outer surface 590, the first case extension portion 581, the first claw portion 591, the second case extension portion 582, and the second claw portion 592. The bus bar insertion side case outer surface 590 is an outer surface of the case 50 that intersects with longitudinal direction DL. The first case extension portion 581 and the second case extension portion 582 extend from the bus bar insertion side case outer surface 590 in the longitudinal direction DL. The first claw portion 591 is connected to the first case extension portion 581, and extends from the first case extension portion 581 in a direction intersecting with the direction in which the first case extension portion 581 extends, here in the width direction DW. The second claw portion 592 is connected to the second case extension portion 582, and extends from the second case extension portion 582 in a direction intersecting with the direction in which the second case extension portion 582 extends, here in the width direction DW. Further, the first claw portion 591 is in contact with the second extension portion 122, thereby restricting movement of the bus bar 10 in the width direction DW and the longitudinal direction DL. Further, the second claw portion 592 is in contact with the fourth extension portion 124, thereby restricting movement of the bus bar 10 in the width direction DW and the longitudinal direction DL.

In such manner, it becomes difficult for the position of the bus bar 10 to misaligned relative to the case 50. Therefore, connecting the bus bar 10 to the detection target is made easy. Further, a contact force between the first claw portion 591 and the second extension portion 122, and a contact force between the second claw portion 592 and the fourth extension portion 124 are smaller than the fixing force by the screw fastening or the like. Therefore, the stress applied to the case 50 is smaller than when the bus bar 10 and the case 50 are fixed together by screws or the like. Therefore, damage to the case 50 is suppressed.

[12-2] The first case extension portion 581 and the second case extension portion 582 are deformed when the bus bar 10 is inserted into the case 50.

In such manner, it becomes easier to insert the bus bar 10 into the case 50 with a single action. Therefore, it becomes easier to assemble the bus bar 10 and the case 50.

### (Modification of Third Embodiment)

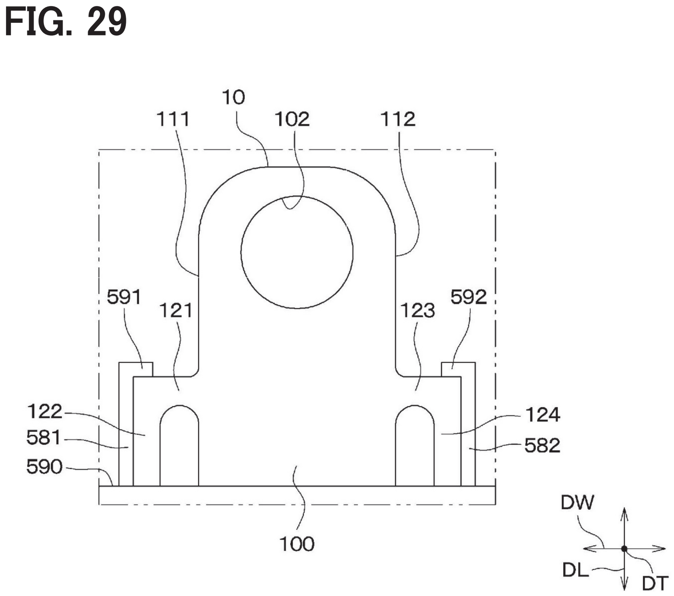

In the third embodiment, as shown in FIG. 29, the second extension portion 122 does not have to have the first claw recess 141. Further, the fourth extension portion 124 does not have to have the second claw recess 142. Even in such configuration, the same effects as those of the third embodiment are achievable.

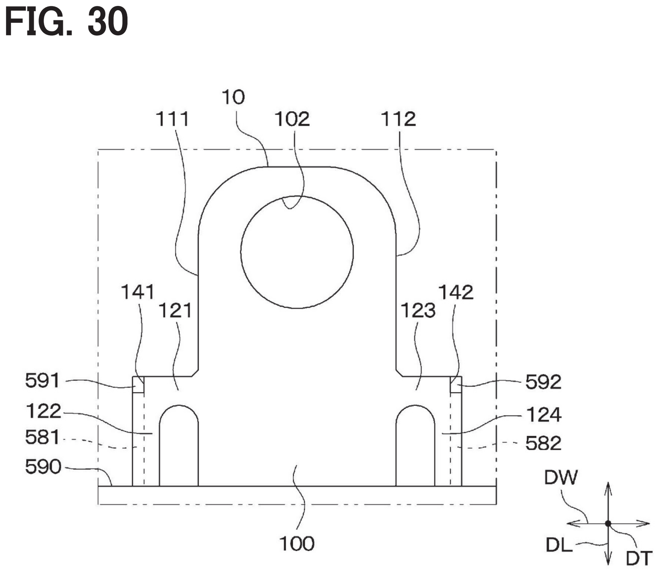

Also, as shown in FIG. 30, the first case extension portion 581 may be positioned outside the second extension portion 122 in the thickness direction DT, instead of being positioned outside the second extension portion 122 in the width direction DW. In such case, the first claw portion 591 extends from the first case extension portion 581 in the thickness direction DT. Further, the second case extension portion 582 may be positioned outside the fourth extension portion 124 in the thickness direction DT, instead of being positioned outside the fourth extension portion 124 in the width direction DW. In such case, the second claw portion 592 extends from the second case extension portion 582 in the thickness direction DT. Even in such configuration, the same effects as those of the third embodiment are achievable.

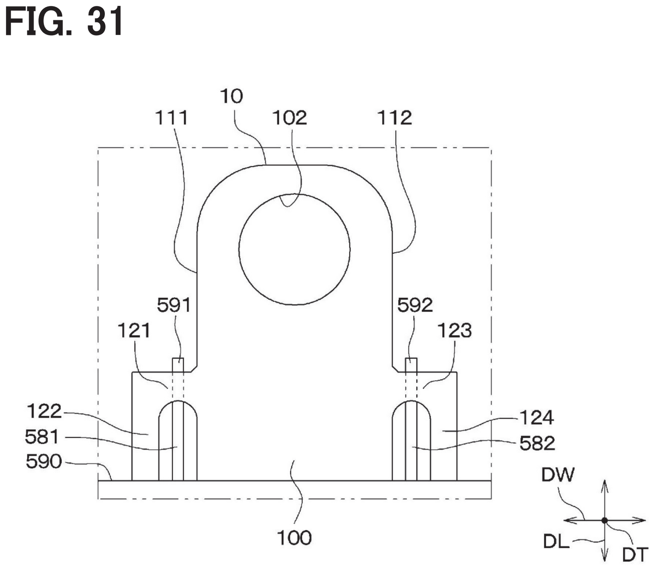

Also, as shown in FIG. 31, the first claw portion 591 may restrict movement of the bus bar 10 in the longitudinal direction DL and the width direction DW by contacting the first extension portion 121 instead of the second extension portion 122. Further, the second claw portion 592 may restrict movement of the bus bar 10 in the longitudinal direction DL and the width direction DW by contacting the third extension portion 123 instead of the fourth extension portion 124. Even in such configuration, the same effects as those of the third embodiment are achievable.

### (Fourth Embodiment)

In the fourth embodiment, the shape of the bus bar 10 is different from that of the first embodiment. The other configurations are the same as those of the first embodiment.

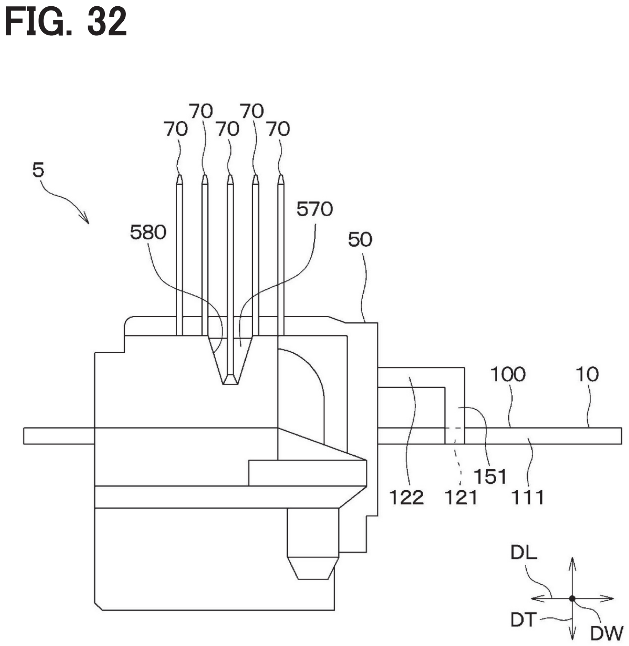

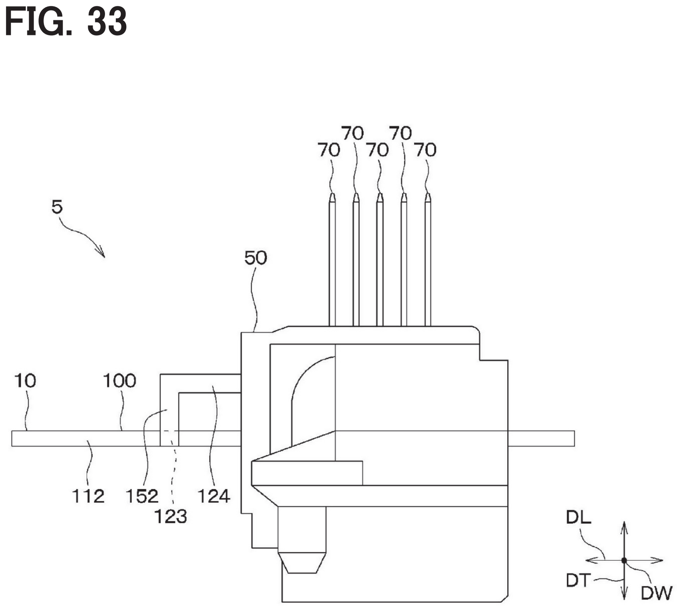

Specifically, as shown in FIGS. 32 and 33, the bus bar 10 further includes a first intermediate portion 151 and a second intermediate portion 152.

The first intermediate portion 151 is connected to one side of the first extension portion 121 opposite to the first side face 111. Further, the first intermediate portion 151 extends from the first extension portion 121 in a direction intersecting with the direction in which the first extension portion 121 extends, which is the thickness direction DT. Further, the second extension portion 122 is connected to one side of the first intermediate portion 151 opposite to the first extension portion 121. Further, the second extension portion 122 extends from the first intermediate portion 151 in a direction intersecting with the direction in which the first intermediate portion 151 extends, which is the longitudinal direction DL. Note that, though the first intermediate portion 151 is formed in a straight line shape extending in a direction intersecting with the direction in which the first extension portion 121 extends, the shape is not limited to such configuration. The first intermediate portion 151 may be formed, for example, in a curved or wavy shape.

The second intermediate portion 152 is connected to one side of the third extension portion 123 opposite to the second side face 112. Further, the second intermediate portion 152 extends from the third extension portion 123 in a direction intersecting with the direction in which the third extension portion 123 extends, which is the thickness direction DT. Further, the fourth extension portion 124 is connected to one side of the second intermediate portion 152 opposite to the third extension portion 123. Further, the fourth extension portion 124 extends from the second intermediate portion 152 in a direction intersecting with the direction in which the second intermediate portion 152 extends, which is the longitudinal direction DL. Further, the second intermediate portion 152 is formed in a straight line shape extending in a direction intersecting with the direction in which the third extension portion 123 extends, the shape is not limited to such configuration. The second intermediate portion 152 may be formed, for example, in a curved or wavy shape.

The current sensor 5 of the fourth embodiment is configured as described above. The fourth embodiment achieves effects similar to those achieved by the first embodiment.

### (Fifth Embodiment)

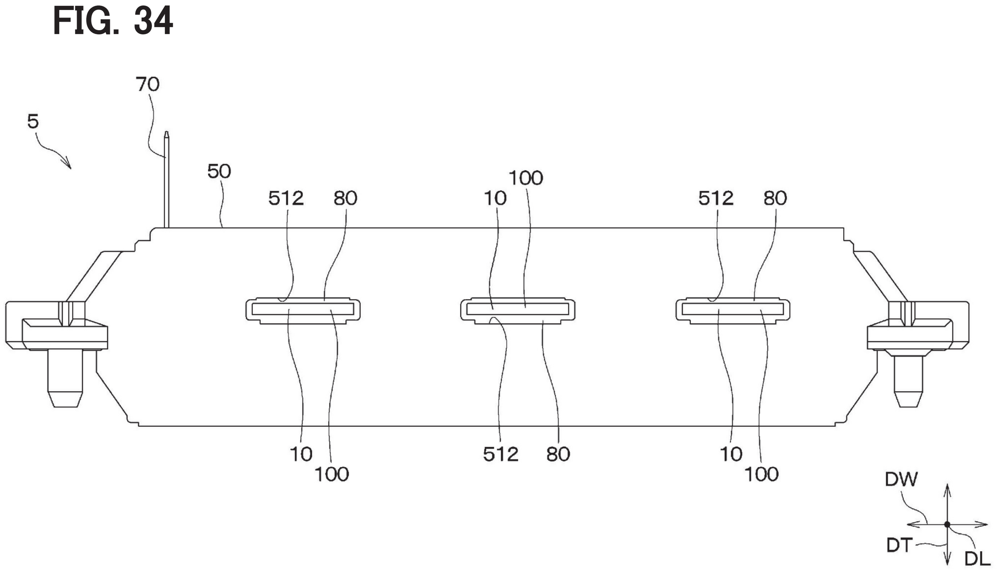

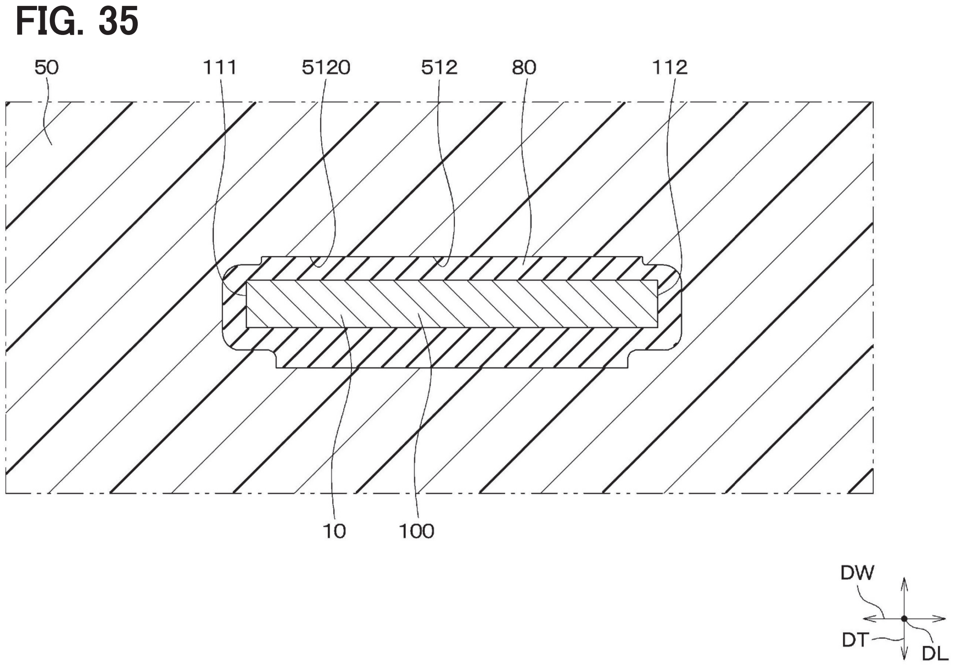

In the fifth embodiment, as shown in FIGS. 34 and 35, the bus bar 10 does not have the first extension portion 121, the second extension portion 122, the third extension portion 123, and the fourth extension portion 124. The current sensor 5 further includes a deformable member 80. The other configurations are similar to those of the first embodiment.

The deformable member 80 is formed at a position between the opening 512 and the current path portion 100, and is thereby covered by the opening 512 and also covers the current path portion 100. Therefore, the deformable member 80 is formed at a position between (a) the bus bar 10 and (b) the opening face 5120, which corresponds to a surface of the opening 512 facing the bus bar 10 in the thickness direction DT. Further, when the bus bar 10 deforms in the thickness direction DT, the deformable member 80 deforms in the thickness direction DT together with the bus bar 10, for example, compresses and expands. Further, the deformable member 80 is made of an elastic material such as rubber. In such manner, the Young's modulus of the deformable member 80 is smaller than the Young's modulus of the bus bar 10. Further, the thermal conductivity of the deformable member 80 is smaller than the thermal conductivity of the bus bar 10. Note that the Young's modulus and the thermal conductivity of the deformable member 80 are estimated, for example, from the Young's modulus and the thermal conductivity of the material of the deformable member 80, respectively. Further, the Young's modulus and the thermal conductivity of the bus bar 10 are estimated, for example, from the Young's modulus and the thermal conductivity of the material of the bus bar 10, respectively.

As described above, the Young's modulus of the deformable member 80 is smaller than the Young's modulus of the bus bar 10. Therefore, since the deformable member 80 is easily deformable than the bus bar 10, stress energy generated by deformation of the bus bar 10 when connecting the bus bar 10 to a detection target such as an inverter (not shown) is easily absorbable. Therefore, the stress applied to the case 50 that accommodates a part of the bus bar 10, the core 20, and the detection element 31 is reducible. Therefore, damage to the case 50 is suppressed.

The current sensor 5 of the fifth embodiment is configured as described above. The current sensor 5 of the fifth embodiment achieves effects similar to those achieved by the first embodiment.

### (Sixth Embodiment).

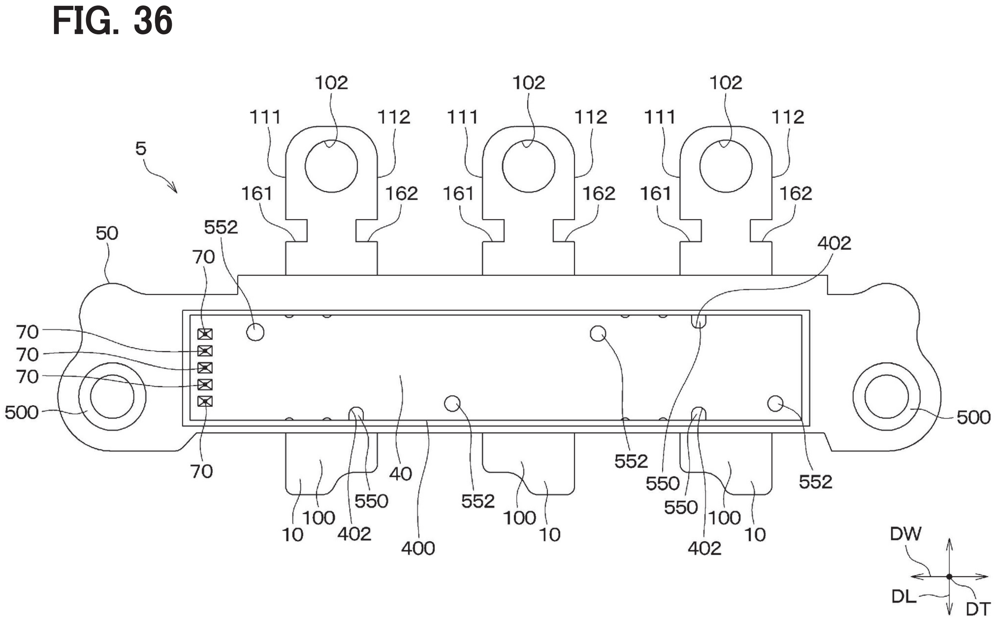

In the sixth embodiment, the bus bar 10 has a first bus bar recess 161 and a second bus bar recess 162, instead of the first extension portion 121, the second extension portion 122, the third extension portion 123, and the fourth extension portion 124, as shown in FIG. 36. The other configurations are the same as those of the first embodiment.

The first bus bar recess 161 corresponds to a first recess, and is recessed in the width direction DW from a region of a portion of the first side face 111 where the current path portion 100 protrudes from the case 50. In such manner, the portion of the current path portion 100 adjacent to the first bus bar recess 161 in the width direction DW has a smaller cross-sectional area compared to other portion where the first bus bar recess 161 is not formed, and therefore is subjected to greater stress, making it more susceptible to deformation. Note that the first bus bar recess 161 may be recessed from an inside of the current path portion 100 in the thickness direction DT. Further, instead of the first bus bar recess 161, a through hole extending from the inside of the current path portion 100 in the thickness direction DT may be formed.

The second bus bar recess 162 corresponds to a second recess, and is recessed in the width direction DW from a region of a portion of the second side face 112 where the current path portion 100 protrudes from the case 50. In such manner, the portion of the current path portion 100 adjacent to the second bus bar recess 162 in the width direction DW has a smaller cross-sectional area compared to the portion where the second bus bar recess 162 is not formed, and therefore is subjected to greater stress, making it more susceptible to deformation. The second bus bar recess 162 may be recessed from an inside of the current path portion 100 in the thickness direction DT. Further, instead of the second bus bar recess 162, a through hole extending from the inside of the current path portion 100 in the thickness direction DT may be formed.

In such manner, the bus bar 10 is easily deformable, thereby easily absorbing stress energy generated by deformation of the bus bar 10 when connecting the bus bar 10 to a detection target such as an inverter (not shown). Therefore, the stress applied to the case 50 that accommodates a part of the bus bar 10, the core 20, and the detection element 31 is reducible. Therefore, damage to the case 50 is suppressed.

The current sensor 5 of the sixth embodiment is configured as described above. The current sensor 5 of the sixth embodiment also achieves similar effects as those achieved by the first embodiment.

### (Seventh Embodiment)

In the seventh embodiment, the shape of the case protrusion 508 is different from that in the first embodiment. The other configurations are the same as those of the first embodiment.

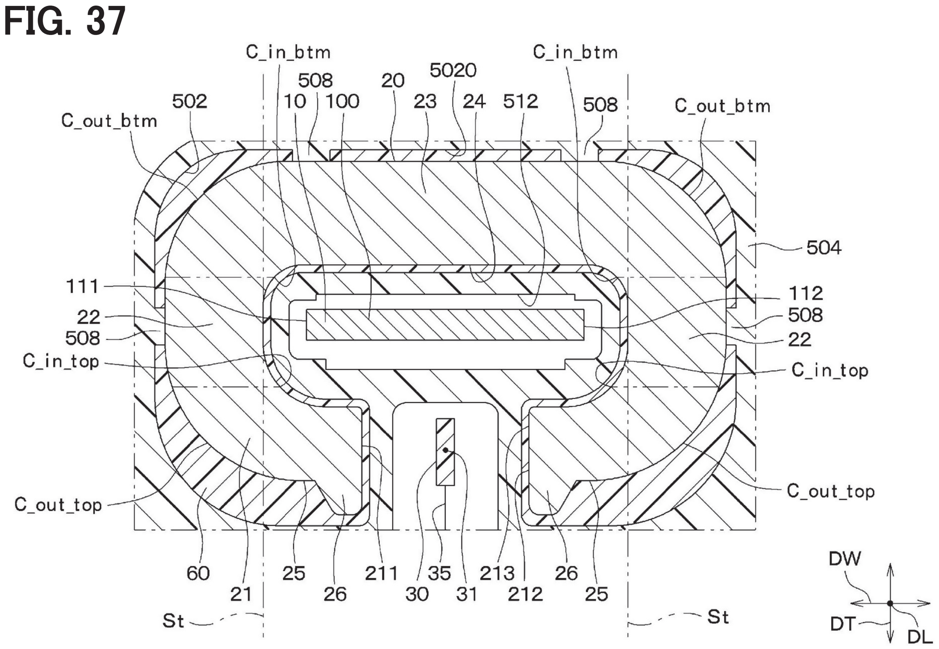

Specifically, as shown in FIG. 37, the case protrusion 508 protrudes from an opposing surface 5020 in the width direction DW and thickness direction DT, instead of protruding from the case facing surface 506 in the longitudinal direction DL. In such manner, the case protrusion 508 is in contact with the core 20. Note that the opposing surface 5020 is one of the inner surfaces forming the core accommodating chamber 502 that faces the core 20 in the width direction DW and thickness direction DT.

The current sensor 5 of the seventh embodiment is configured as described above. The current sensor 5 of the seventh embodiment also achieves similar effects as those achieved by the first embodiment.

### (Eighth Embodiment)

In the eighth embodiment, the bus bar 10 has a bus bar protrusion 133, instead of the first bus bar protrusion 131 and the second bus bar protrusion 132. Further, the opening 512 does not have the opening protrusion 5122. The other configurations are similar to those of the first embodiment.

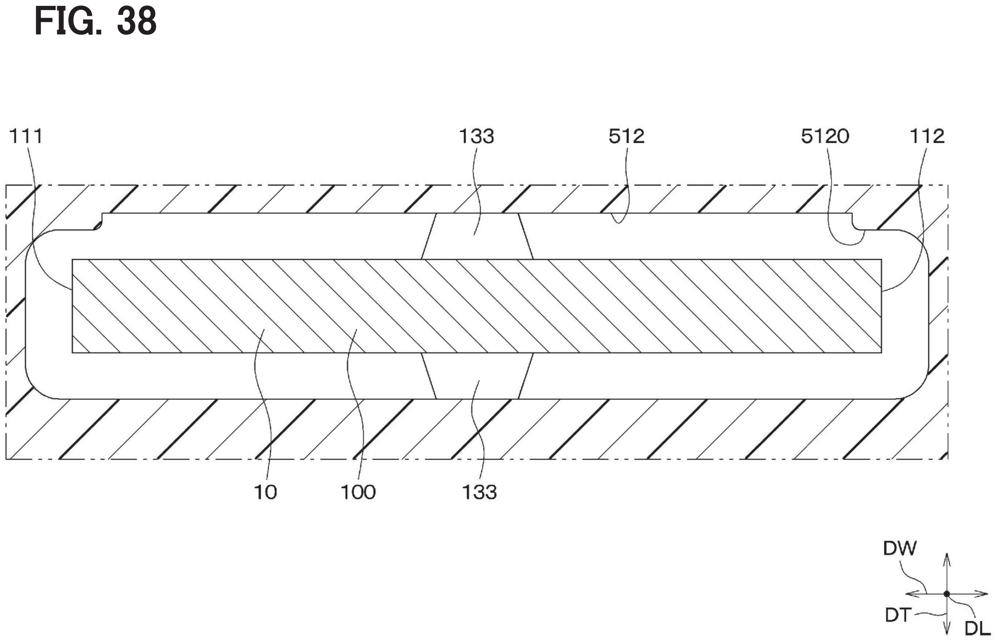

As shown in FIG. 38, the bus bar protrusion 133 protrudes in the thickness direction DT from a surface of the current path portion 100 that is perpendicular to the thickness direction DT. In such manner, the bus bar protrusion 133 is in contact with the opening 512. Therefore, a space is formed at a position between the opening 512 and the bus bar 10.

The current sensor 5 of the eighth embodiment is configured as described above. The current sensor 5 of the eighth embodiment also achieves similar effects as those achieved by the first embodiment.

### (Ninth Embodiment)

In the ninth embodiment, the arrangement of the current sensor 5 is different from that in the first embodiment. The other configurations are the same as those of the first embodiment.

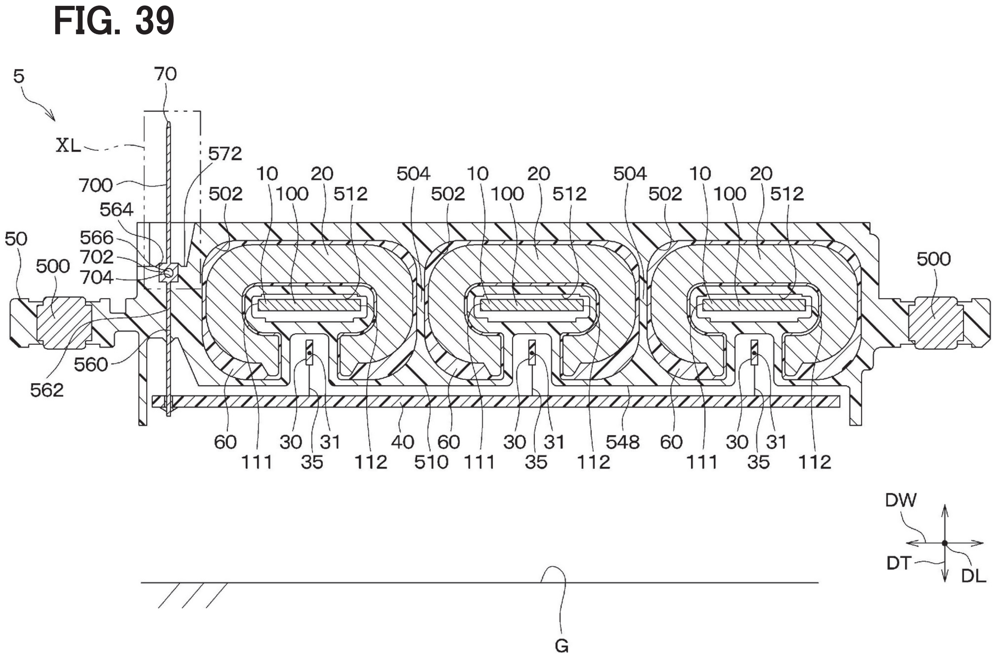

Specifically, as shown in FIG. 39, the gap 213 is arranged closer to a ground G than the bus bar 10. Further, the detection element 31, the lead wire 35 and the substrate 40 are arranged closer to the ground G than the bus bar 10.

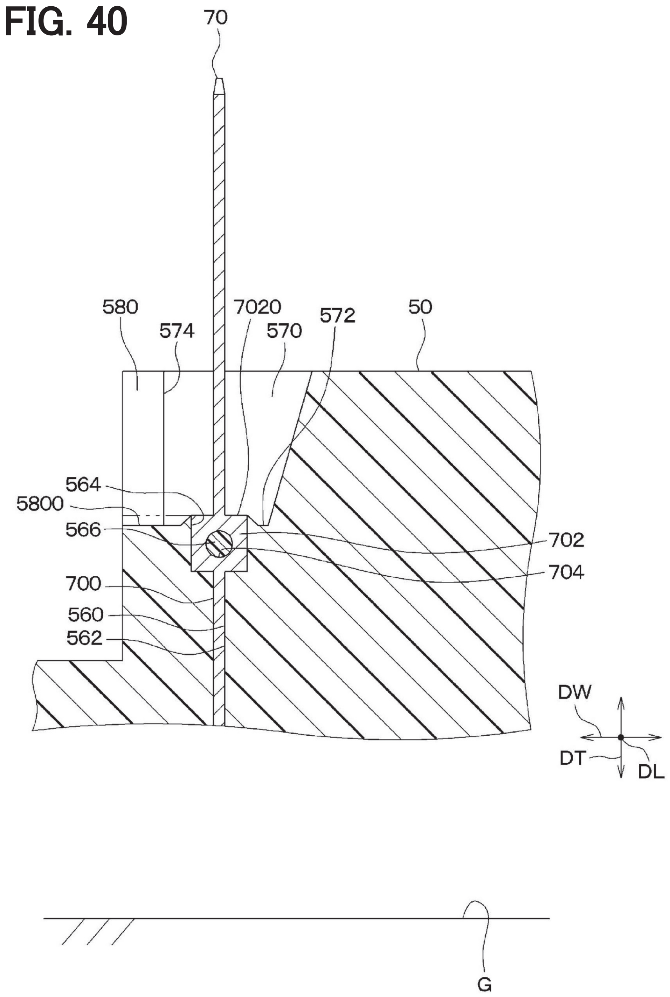

As also shown in FIG. 40, the liquid discharge portion 580 includes a discharge surface 5800. The discharge surface 5800 is a surface of the liquid discharge portion 580 that is perpendicular to the thickness direction DT, and corresponds to a surface that intersects with the thickness direction DT. Further, the discharge surface 5800 is connected to the recess bottom surface 572. Further, the discharge surface 5800 is arranged closer to the ground G than the exposed portion 7020.

The current sensor 5 of the ninth embodiment is configured as described above. The current sensor 5 of the ninth embodiment also achieves similar effects as those achieved by the first embodiment. Further, in the ninth embodiment, the following effects are also achievable.

[13-1] Here, thermal convection caused by heat generated by the electric current flowing through the bus bar 10 tends to flow toward an opposite side of the ground G, i.e., toward a top side, because the density of the air is low.

In contrast, in the current sensor 5 of the ninth embodiment, the detection element 31, the lead wire 35 and the substrate 40 are arranged closer to the ground G than the bus bar 10.

In such manner, the detection element 31, the lead wire 35 and the substrate 40 are arranged on one side opposite to the top side. Therefore, heat from thermal convection, which is caused by heat generation by the electric current flowing through the bus bar 10, is less likely to be transmitted to the detection element 31, the lead wire 35, and the substrate 40. Therefore, damage to the detection element 31, the lead wire 35 and the substrate 40 is suppressed.

[13-2] The discharge surface 5800 is arranged closer to the ground G than the exposed portion 7020. In such manner, it becomes easier for liquid such as water remaining in the exposed portion 7020 to be discharged via the discharge surface 5800 by gravity. Therefore, corrosion of the exposed portion 7020 is suppressed, thereby suppressing corrosion of the terminal 70.

### (Tenth Embodiment)

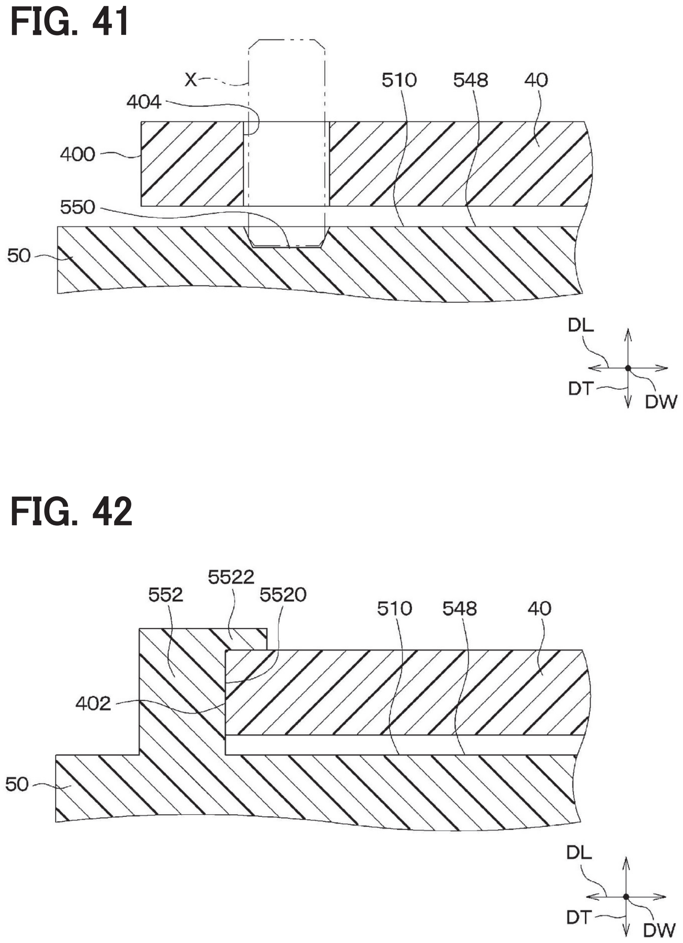

In the tenth embodiment, as shown in FIG. 41, the substrate 40 does not have the substrate notch 402. Further, the substrate hole 404 communicates with the substrate recess 550 in the thickness direction DT. The other configurations are similar to those of the first embodiment. The current sensor 5 of the tenth embodiment also achieves similar effects as those achieved by the first embodiment.

### (Eleventh Embodiment)

In the eleventh embodiment, as shown in FIG. 42, the substrate protrusion 552 is inserted into the substrate notch 402 instead of being inserted into the substrate hole 404. The other configurations are the same as those of the first embodiment. The current sensor 5 of the eleventh embodiment also achieves similar effects as those achieved by the first embodiment.

### (Twelfth Embodiment)

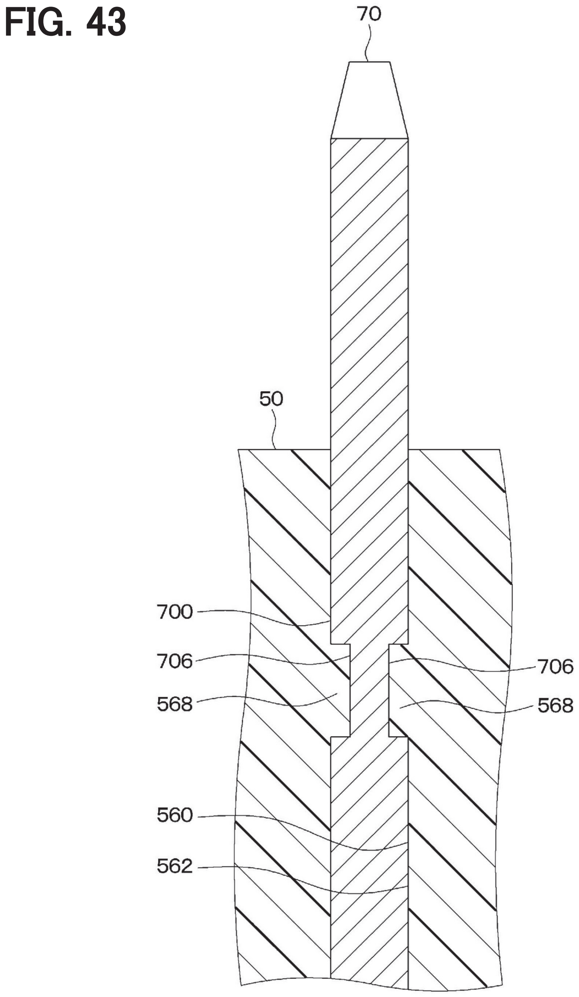

In the twelfth embodiment, as shown in FIG. 43, the terminal 70 has a terminal recess 706 instead of the terminal flange 702 and the terminal hole 704. Further, the case 50 has a terminal flange 568 instead of the terminal recess 564. The other configurations are similar to those of the first embodiment.

The terminal recess 706 is recessed from the terminal side face 700 in a direction perpendicular to the direction in which the terminal 70 extends, that is, i.e., in the width direction DW.

The terminal flange 568 corresponds to a case flange, and protrudes from the terminal inner surface 562 in a direction in which the terminal recess 706 is recessed, that is, i.e., in the width direction DW. Further, the terminal flange 568 is in contact with the terminal recess 706, thereby restricting movement of the terminal 70.

The current sensor 5 of the twelfth embodiment is configured as described above. The current sensor 5 of the twelfth embodiment also achieves similar effects as those achieved by the first embodiment.

### (Other Embodiments)

The present disclosure is not limited to the above-described embodiments, and the above-described embodiments can be appropriately modified. Further, individual elements or features of a particular embodiment are not necessarily essential unless it is specifically stated that the elements or the features are essential in the foregoing description, or unless the elements or the features are obviously essential in principle.

In each of the above embodiments, the current sensor 5 is used in an inverter, but is not limited to such configuration, and may be used in, for example, a BMS. Note that BMS is an abbreviation for Battery Management System.

In each of the above embodiments, the width of the bus bar 10 is greater than the thickness of the bus bar 10, but the present disclosure is not limited to the above. The thickness of the bus bar 10 may be greater than the width of the bus bar 10.

In each of the above-described embodiments, the core 20 is formed by bending a plate-shaped soft magnetic material into a C-shape, but the present disclosure is not limited to such configuration. For example, the core 20 may be formed by wire-cutting a plate-shaped soft magnetic material. Further, the core 20 may be formed by winding a sheet-like soft magnetic material. In such case, an adhesive material is used to prevent separation between the soft magnetic materials. Further, the core 20 may be formed by stacking sheet-like soft magnetic materials one on top of the other. In such case, a plurality of soft magnetic materials are formed into sheets by pressing, and the sheets of soft magnetic material are laminated by dowel caulking.

Also, assume that the core 20 is made of laminated plate-shaped permalloy. In such case, the hysteresis characteristic of the core 20 is improved compared to when the core 20 is made of laminated plate-shaped grain-oriented electromagnetic steel sheets. Further, it is assumed that the core 20 is formed from a plate-shaped grain-oriented electromagnetic steel sheet. In such case, the cost of materials is reducible compared to when the core 20 is made of permalloy, and therefore the cost of the current sensor 5 can be reduced.

In each of the above-described embodiments, the first end face 211 and the second end face 212 are formed to have a flat surface, but the present disclosure is not limited to such configuration. The first end face 211 and the second end face 212 may be formed to have a spherical or curved shape.

In each of the above-described embodiments, the bus bar 10 is formed in a plate shape, but is not limited thereto and may be formed in a rod shape, column shape, or the like. Therefore, in the present specification, the bus bar 10 being formed in a plate shape also means that the bus bar 10 is formed in a rod shape, column shape, or the like.

The above-described embodiments and modifications may be combined as appropriate.

### (Aspects of the Present Disclosure)

As is apparent from the above description of the embodiments and modifications, the disclosure of the present specification includes at least the following aspects.

### (Subject)

According to a study by the inventor and others, when the bus bar, the one described in the Patent Literature 1 or the like, is connected to the detection target by a bolt or the like, the bus bar is deformed. At such time, stress is applied to the bus bar, which in turn applies stress to a case that accommodates the bus bar. In such manner, the case may be damaged.

It is an object of the present disclosure to provide a current sensor that suppresses damage to the case.

### [Aspect 1-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by an electric current flowing through the current path portion; and a case (50) accommodating a portion of the bus bar, the core, and the detection element, in which the bus bar includes: a side face (111) of the current path portion that intersects with the width direction; a first extension portion (121) that extends in the width direction from a region of a portion of the side face where the current path portion protrudes from the case; a second extension portion (122) that is connected to the first extension portion and extends in a direction intersecting with an extending direction of the first extension portion, and the second extension portion deforms in the thickness direction while coming into contact with the case when the current path portion deforms in the thickness direction.

### [Aspect 1-2]

The current sensor of aspect 1-1, in which the side face is a first side face, the bus bar includes: a second side face (112) of the current path portion that is positioned on an opposite side to the first side face and intersects with the width direction; a third extension portion (123) extending in the width direction from a region of a portion of the second side face where the current path portion protrudes from the case; and a fourth extension portion (124) connected to the third extension portion and extending in a direction intersecting with the direction in which the third extension portion extends, and the fourth extension portion deforms in the thickness direction while coming into contact with the case when the current path portion deforms in the thickness direction.

### [Aspect 1-3]

The current sensor of aspect 1-1 or 1-2, in which the case includes: a case outer surface (590) which is an outer surface of the case intersecting with the longitudinal direction (DL) of the current path portion; a case extension portion (581) extending in the longitudinal direction from the case outer surface; and a claw portion (591) connected to the case extension portion and extending from the case extension portion in a direction intersecting with the direction in which the case extension portion extends, and the claw portion is in contact with the second extension portion to restrict movement of the bus bar in the width direction and the longitudinal direction.

### [Aspect 1-4]

The current sensor of aspect 1-3, in which the case extension portion deforms when the bus bar is inserted into the case.

### [Aspect 1-5]

The current sensor of aspect 1-3 or 1-4, in which the case extension portion is positioned outside in the width direction relative to the second extension portion, and the claw portion extends in the width direction from the case extension portion.

### [Aspect 1-6]

The current sensor of aspect 1-1 or 1-2, in which the case includes: a case outer surface (572 ) which is an outer surface of the case intersecting with the longitudinal direction (DL) of the current path portion; a case extension portion (581) extending in the longitudinal direction from the case outer surface; and a claw portion (591) connected to the case extension portion and extending from the case extension portion in a direction intersecting with the direction in which the case extension portion extends, in which the claw portion is in contact with the first extension portion to restrict movement of the bus bar in the width direction and the longitudinal direction.

### [Aspect 1-7]

The current sensor of any one of aspects 1-1 to 1-6, in which the case includes: a hole (531) into which at least a portion of the second extension portion is inserted; an inner surface (521) forming the hole and faces the second extension portion in the width direction and the thickness direction; and a protrusion (541) protruding from the inner surface toward the second extension portion and being in contact with the second extension portion.

### [Aspect 1-8]

The current sensor of any one of aspects 1-1 to 1-7, in which a length of the second extension portion in the width direction is shorter than a length of the current path portion in the width direction.

### [Aspect 1-9]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect the intensity of a magnetic field generated by an electric current flowing through the current path portion; and a case (50) accommodating a portion of the bus bar, the core, and the detection element, in which the bus bar includes: a side face (111) of the current path portion that intersects with the width direction; a first extension portion (121) that extends in the width direction from a region of a portion of the side face where the current path portion protrudes from the case; and a second extension portion (122) that is connected to the first extension portion and extends in a direction intersecting with an extending direction of the first extension portion, and a cross-sectional area of the second extension portion when cut in a direction perpendicular to the longitudinal direction (DL) of the current path portion is smaller than a cross-sectional area of the current path portion when cut in a direction perpendicular to the longitudinal direction.

### [Aspect 1-10]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect the intensity of a magnetic field generated by an electric current flowing through the current path portion; and a case (50) accommodating a portion of the bus bar, the core, and the detection element, in which the bus bar includes: a side face (111) of the current path portion that intersects with the width direction; a first extension portion (121) that extends in the width direction from a region of a portion of the side face where the current path portion protrudes from the case; an intermediate portion (151) connected to the first extension portion and extending in a direction intersecting with the direction in which the first extension portion extends; and a second extension portion (122) connected to the intermediate portion and extending in a direction intersecting with the direction in which the intermediate portion extends, and the second extension portion deforms in the thickness direction while coming into contact with the case when the current path portion deforms in the thickness direction.

### [Aspect 2-1]

A current sensor including: a bus bar (10) formed in a plate shape and through which an electric current flows; a core (20) including a core hole (24) into which the bus bar is inserted, a gap forming portion (21) including a first end face (211) facing a width direction (DW) of the bus bar, a second end face (212) facing the first end face in the width direction, and a gap (213) formed by the first end face and the second end face and communicating with the core hole and the outside, a core side portion (22) connected to the gap forming portion and extending in a thickness direction (DT) of the bus bar, and a core bottom portion (23) connected to the core side portion and extending in the width direction and forming the core hole together with the gap forming portion and the core side portion; a detection element (31) arranged in the gap and configured to detect an intensity of a magnetic field generated by an electric current flowing through the bus bar; a case (50) having (a) an accommodating chamber (510) that accommodates the detection element and (b) an opening (512) which is inserted into the core hole and into which the bus bar is inserted; and a deformable member (80) formed at a position between (a) an opening face (5120) of the opening facing the bus bar in the thickness direction and (b) the bus bar, in which the deformable member deforms in the thickness direction together with the bus bar when the bus bar deforms in the thickness direction, and a Young's modulus of the deformable member is smaller than the Young's modulus of the bus bar.

### [Aspect 3-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by an electric current flowing through the current path portion; and a case (50) accommodating a portion of the bus bar, the core, and the detection element, in which the bus bar includes: a side face (111) of the bus bar that intersects with the width direction; and a recess (161) recessed in the width direction from a region of a portion of the side face where the bus bar protrudes from the case.

### [Aspect 3-2]

The current sensor of aspect 3-1, in which the side face is a first side face, the recess is a first recess, and the bus bar includes: a second side face (112) of the bus bar that is positioned on and opposite side to the first side face and intersects with the width direction; and a second recess (162) recessed in the width direction from a region of a portion of the second side face where the bus bar protrudes from the case.

### (Subject)

According to a study by the inventor or others, a case of a current sensor such as the one described in Patent Literature 1 is subjected to stress due to (a) forces from outside the case, such as the force generated when connecting the bus bar to a detection target such as an inverter, and (b) heat generation due to an electric current flowing through the bus bar. Further, when a plurality of bus bars, cores, and sensor chips are accommodated in the case, the space inside the case needs to be large. Therefore, the rigidity of the case lowers. Thus, due to the stress applied to the case, the case is subject to deformation such as warpage or the like. The present disclosure aims to provide a current sensor that improves the rigidity of the case.

### [Aspect 4-1]

A current sensor including: a first bus bar (10) formed in a plate shape and through which an electric current flows; a first core (20) having a first core hole (24) into which the first bus bar is inserted, a first gap forming portion (21) including a first end face (211) facing in a width direction (DW) of the first bus bar, a second end face (212) facing the first end face in the width direction, and a first gap (213) formed by the first end face and the second end face and communicating with the first core hole and an outside, a first core side portion (22) connected to the first gap forming portion and extending in a thickness direction (DT) of the first bus bar, and a first core bottom portion (23) connected to the first core side portion and extending in the width direction and forming the first core hole together with the first gap forming portion and the first core side portion; a first detection element (31) arranged in the first gap and configured to detect an intensity of a magnetic field generated by an electric current flowing through the first bus bar; a second bus bar (10) formed in a plate shape and through which an electric current flows; a second core (20) having a second core hole (24) into which the second bus bar is inserted, a second gap forming portion (21) including a third end face (211) facing in the width direction (DW), a fourth end face (212) facing the third end face in the width direction, and a second gap (213) formed by the third end face and the fourth end face and communicating with the second core hole and an outside, a second core side portion (22) connected to the second gap forming portion and extending in the thickness direction (DT), and a second core bottom portion (23) connected to the second core side portion and extending in the width direction and forming the second core hole together with the second gap forming portion and the second core side portion; a second detection element (31) arranged in the second gap and configured to detect an intensity of a magnetic field generated by an electric current flowing through the second bus bar; and a case (50) accommodating the first bus bar, the first core, the first detection element, the second bus bar, the second core, and the second detection element, in which the first core and the second core are arranged at an interval in the width direction, the case includes: a first accommodating chamber (502) that accommodates the first core; a second accommodating chamber (502) that accommodates the second core; and a partition portion (504) that separates the first accommodating chamber and the second accommodating chamber.

### [Aspect 4-2]

The current sensor of aspect 4-1 further includes: a first resin portion (60) that is formed of resin at a position between an inner surface that forms the first accommodating chamber and a surface of the first core, and is thereby connected to (a) the inner surface that forms the first accommodating chamber and (b) the surface of the first core, and that covers the first core; and a second resin portion (60) that is formed of resin at a position between an inner surface that forms the second accommodating chamber and a surface of the second core, and is thereby connected to (a) the inner surface that forms the second chamber and (b) the surface of the second core, and that covers the second core.

### [Aspect 4-3]

The current sensor of aspect 4-2, in which the case includes: a first facing surface (506) which is an inner surface forming the first accommodating chamber and which faces the first core and the first bus bar in a longitudinal direction (DL); and a second facing surface (506) which is an inner surface forming the second chamber and which faces the second core in the longitudinal direction, the first core has a first core surface (27) which is a surface of the first core opposite to the first facing surface, the second core has a second core surface (27) which is a surface of the second core opposite to the second facing surface, the first resin portion covers the first core surface and also covers the partition portion, and the second resin portion covers the second core surface and also covers the partition portion, and is connected to the first resin portion.

### (Subject)

According to a study by the inventor and others, when the force used to fix the case and core of a current sensor as described in Patent Literature 1 is small, the position of the core relative to the case is likely to be misaligned. Further, when the position of the core is misaligned, the bus bars and the sensor chip will also be misaligned relative to the core. Therefore, the detection accuracy of the magnetic field intensity by the sensor chip deteriorates due to fluctuations in the magnetic field and changes in the detection position of the magnetic field intensity. Therefore, the current detection accuracy of the current sensor deteriorates. An object of the present disclosure is to provide a current sensor that suppresses deterioration in current detection accuracy.

### [Aspect 5-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by an electric current flowing through the current path portion; a case (50) including a core accommodating chamber (502) that accommodates the core; and a resin filler (60) formed of resin at a position between (a) an inner surface forming the core accommodating chamber and (b) a surface of the core, and thereby connected to the inner surface forming the core accommodating chamber and the surface of the core, and covering the core, in which the case includes: a case facing surface (506) which is an inner surface forming the core accommodating chamber that faces the core in the longitudinal direction (DL) of the bus bar; and a case protrusion (508) protruding from the case facing surface in the longitudinal direction to form a space between the case facing surface and a surface of the core facing the case facing surface in the longitudinal direction, and the resin filler is formed at a position between the case facing surface and a surface of the core that faces the case facing surface in the longitudinal direction, thereby being connected to the case facing surface and the surface of the core that faces the case facing surface in the longitudinal direction.

### [Aspect 5-2]

The current sensor of aspect 5-1, in which the case protrusion is in contact with the core.

### [Aspect 5-3]

The current sensor of aspect 5-2, in which three or more case protrusions are formed, and a plane is formed by straight lines connecting the case protrusions with each other.

### (Subject)

According to a study by the inventor and others, when the position of the core relative to the case of the current sensor described in Patent Literature 1 is misaligned, the positions of the bus bar and the sensor chip relative to the core are also misaligned. Therefore, the detection accuracy of the magnetic field intensity by the sensor chip deteriorates due to fluctuations in the magnetic field and changes in the detection position of the magnetic field intensity. Therefore, the current detection accuracy of the current sensor deteriorates. An object of the present disclosure is to provide a current sensor that suppresses deterioration in current detection accuracy.

### [Aspect 6-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by an electric current flowing through the current path portion; and a case (50) accommodating a portion of the bus bar, the core, and the detection element, in which the case includes a case protrusion (508), and the case protrusion is in contact with the core, when protruding toward the core from an inner surface that forms the core accommodating chamber.

### [Aspect 6-2]

The current sensor of aspect 6-1, in which the case includes a case facing surface (506) which is an inner surface forming the core accommodating chamber that faces the core in the longitudinal direction (DL) of the bus bar, and the case protrusion protrudes from the case facing surface in the longitudinal direction, contacting the core in the longitudinal direction.

### [Aspect 6-3]

The current sensor of aspect 6-1, in which the case protrusion protrudes in the width direction from an opposing surface (5020) of the core accommodating chamber that opposes the core in the width direction, thereby contacting the core in the width direction.

### [Aspect 6-4]

The current sensor described in aspect 6-1, in which the case protrusion protrudes in the thickness direction from an opposing surface (5020) of the core accommodating chamber that opposes the core in the thickness direction, thereby contacting the core in the thickness direction.

### [Aspect 6-5]

The current sensor of any one of aspects 6-1 to 6-4, in which a plane is formed by straight lines connecting the case protrusions with each other.

### (Subject)

According to a study by the inventor and others, when an electric current flows through a bus bar of a current sensor such as the one described in Patent Literature 1, the bus bar generates heat. Heat generated by the bus bar may damage the case. It is an object of the present disclosure to provide a current sensor that suppresses damage to the case.

### [Aspect 7-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; and a case (50) accommodating the bus bar, the core, and the detection element, in which the case includes an opening (512) that is inserted into the core hole and into which the bus bar is inserted, the bus bar includes a bus bar protrusion (131, 132) that protrudes from a surface facing the opening toward the opening and is in contact with the opening, and a space is formed at a position between the opening and the bus bar.

### [Aspect 7-2]

The current sensor of aspect 7-1, in which the bus bar includes a side face (111, 112) that intersect with the width direction of the bus bar, and the bus bar protrusion protrudes from the side face in the width direction.

### [Aspect 7-3]

The current sensor of aspect 7-1 or 7-2, in which the bus bar protrusion includes: a contact portion (1310, 1320) in contact with the opening; and an inclined portion (1311, 1321) connected to the contact portion and inclined in a direction in which a size of the bus bar protrusion decreases with increasing distance from a boundary with the contact portion.

### [Aspect 7-4]

The current sensor of any one of aspects 7-1 to 7-3, in which the opening includes: an opening face (5120) facing the bus bar; and an opening protrusion (5122) protruding from the opening face toward the bus bar protrusion and thereby being in contact with the bus bar protrusion.

### [Aspect 7-5]

The current sensor of aspect 7-4, in which the Young's modulus of the opening protrusion is smaller than the Young's modulus of the bus bar protrusion.

### [Aspect 7-6]

The current sensor of aspect 7-4 or 7-5, in which the opening protrusion includes: a protrusion contact portion (5124) in contact with the bus bar protrusion; and a protrusion inclined portion (5126) connected to the protrusion contact portion and inclined in a direction in which a size of the opening protrusion becomes smaller with increasing distance from a boundary with the protrusion contact portion.

### (Subject)

According to a study by the inventor and others, in a current sensor such as the one described in Patent Literature 1, the printed circuit board to which the sensor chip is connected may be accommodated in a case. In such case, when the position of the printed circuit board is misaligned with respect to the case, the position of the sensor chip is also misaligned with respect to the case. Further, when the position of the sensor chip is misaligned, the positions of the core and the bus bars relative to the sensor chip are also misaligned. In such manner, the detection accuracy of the magnetic field intensity by the sensor chip deteriorates due to fluctuations in the magnetic field and changes in the detection position of the magnetic field intensity. Therefore, the current detection accuracy of the current sensor deteriorates. An object of the present disclosure is to provide a current sensor that suppresses deterioration in current detection accuracy.

### [Aspect 8-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; and a case (50) accommodating the bus bar, the core, the detection element, the lead wire, and the substrate, in which the substrate includes: a substrate side face (400); and a substrate notch (402) recessed from the substrate side face, the case includes: a substrate accommodating chamber (510) accommodating the substrate; an accommodating chamber facing surface (548) forming the substrate accommodating chamber and facing the substrate; and a case recess (550) recessed from the accommodating chamber facing surface, and the case recess is formed at a position corresponding to the substrate notch, thereby in communication with the substrate notch.

### [Aspect 8-2]

The current sensor of aspect 8-1, in which three or more substrate notches and three or more case recesses are formed, and a plane is formed by straight lines connecting the substrate notches, and a plane is formed by straight lines connecting the case recesses.

### [Aspect 8-3]

The current sensor of aspect 8-1 or 8-2, in which the gap is arranged closer to a ground (G) than the bus bar, and the detection element, the lead wire and the substrate are arranged on a ground side relative to the bus bar.

### [Aspect 8-4]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; and a case (50) accommodating the bus bar, the core, the detection element, the lead wire, and the substrate, in which the substrate has a substrate hole (404) penetrating an inside therethrough, the case includes: a substrate accommodating chamber (510) accommodating the substrate; an accommodating chamber facing surface (548) forming the substrate accommodating chamber and facing the substrate; and a case recess (550) recessed from the accommodating chamber facing surface, and the case recess is formed at a position corresponding to the substrate hole, thereby in communication with the substrate hole.

### [Aspect 9-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; and a case (50) accommodating the bus bar, the core, the detection element, the lead wire, and the substrate, in which the substrate has a substrate hole (404) penetrating an inside therethrough, the case includes: a substrate accommodating chamber (510) accommodating the substrate; an accommodating chamber facing surface (548) forming the substrate accommodating chamber and facing the substrate; and a case protrusion (552) protruding from the accommodating chamber facing surface toward the substrate hole and inserted into the substrate hole, the case protrusion includes: a protrusion side face (5520) extending in a direction in which the case protrusion extends; and a case flange (5522) extending from the protrusion side face in a direction perpendicular to the direction in which the case protrusion extends, and movement of the substrate is restricted due to (a) positioning of the substrate between the case flange and the accommodating chamber facing surface in the direction in which the case protrusion extends, and (b) contact between the substrate and the case flange.

### [Aspect 9-2]

The current sensor of aspect 9-1, in which three or more substrate holes and three or more case protrusions are formed, and a plane is formed by straight lines connecting the substrate holes with each other, and a plane is formed by straight lines connecting the case protrusions with each other.

### [Aspect 9-3]

The current sensor of aspect 9-1 or 9-2, in which the gap is arranged closer to a ground (G) than the bus bar, and the detection element, the lead wire and the substrate are arranged on a ground side relative to the bus bar.

### [Aspect 9-4]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; and a case (50) accommodating the bus bar, the core, the detection element, the lead wire, and the substrate, the substrate includes: a substrate side face (400); and a substrate notch (402) recessed from the substrate side face, the case includes: a substrate accommodating chamber (510) accommodating the substrate; an accommodating chamber facing surface (548) forming the substrate accommodating chamber and facing the substrate; and a case protrusion (552) protruding from the accommodating chamber facing surface toward the substrate recess and inserted into the substrate recess, the case protrusion includes: a protrusion side face (5520) extending in a direction in which the case protrusion extends; and a case flange (5522) extending from the protrusion side face in a direction perpendicular to the direction in which the case protrusion extends, and movement of the substrate is restricted due to (a) positioning of the substrate between the case flange and the accommodating chamber facing surface in the direction in which the case protrusion extends, and (b) contact between the substrate and the case flange.

### (Subject)

According to a study by the inventor or others, a case of a current sensor such as the one described in Patent Literature 1 is subjected to stress due to (a) forces from outside the case, such as the force generated when connecting the bus bar to a detection target such as an inverter, and (b) heat generation due to an electric current flowing through the bus bar. Further, since the two bus bars are arranged side by side in the width direction, the length of the case in the width direction is longer than the length of the case in the longitudinal direction. At such time, therefore, the amount of warpage, for example, the amount of bending, of the case in the width direction becomes greater than the amount of warpage of the case in the longitudinal direction. Further, in the current sensor described in Patent Literature 1, a plurality of connection terminals are arranged at intervals in the width direction. In such case, the amount of warpage of the case in the width direction is large, and therefore the amount of change in the interval between the connection terminals due to stress applied to the case increases. Therefore, due to the connection terminal easily misaligned, connecting the connection terminal to an external device becomes difficult. Therefore, connection failures between the connection terminals and external devices may be easily caused. An object of the present disclosure is to provide a current sensor that suppresses misalignment of terminals.

### [Aspect 10-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; a plurality of terminals (70) connected to the substrate; and a case (50) accommodating the bus bar, the core, the detection element, the lead wire, the substrate and the terminals, in which at least one of the plurality of terminals outputs a signal from the detection element, a length of the case in the width direction is longer than a length of the case in a longitudinal direction (DL) of the bus bar, and the terminals are arranged at intervals in the longitudinal direction.

### [Aspect 10-2]

The current sensor of aspect 10-1, in which the terminal extends from the substrate in the thickness direction, and thereby protrudes from an outer surface (572) of the case opposite to the substrate.

### [Aspect 10-3]

The current sensor of aspect 10-1 or 10-2, in which a direction of an electric current flowing through the bus bar is the longitudinal direction, and the plurality of terminals are arranged at intervals in a direction of the electric current flowing through the bus bar.

### [Aspect 10-4]

The current sensor according to any one of aspects 10-1 to 10-3, in which a length of the substrate in the width direction is longer than a length of the substrate in the longitudinal direction.

### (Subject)

According to a study by the inventor and others, in a current sensor such as the one described in Patent Literature 1, a magnetic field generated by an electric current flowing through the bus bar passes through the connection terminal. Further, the connection terminals are arranged at intervals in a direction perpendicular to the direction of the electric current flowing through the bus bar. Further, the intensity of the magnetic field generated by the electric current flowing through the bus bar differs depending on the position in the direction perpendicular to the direction of the electric current flowing through the bus bar. Therefore, each connection terminal is affected by a magnetic field of different intensity, and the accuracy of the signal output from the connection terminal decreases. An object of the present disclosure is to provide a current sensor that suppresses deterioration in accuracy of a signal output from a terminal.

### [Aspect 11-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; a plurality of terminals (70) connected to the substrate; and a case (50) accommodating the bus bar, the core, the detection element, the lead wire, the substrate and the terminals, in which at least one of the plurality of terminals outputs a signal from the detection element, the plurality of terminals are arranged at intervals in a direction of an electric current flowing through the bus bar.

### (Subject)

According to a study by the inventor and others, in the current sensor described in Patent Literature 1, the connection terminals protrude from the case. When the connection terminal falls off from the sensor chip or the case, the signal from the sensor chip will no longer be output to the external device. An object of the present disclosure is to provide a current sensor that prevents a terminal from coming off from a case.

### [Aspect 12-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; a plurality of terminals (70) connected to the substrate; and a case (50) accommodating the bus bar, the core, the detection element, the lead wire, the substrate and the terminals, in which the terminal includes: a terminal side face (700) extending in the direction in which the terminal extends; a terminal flange (702) extending in a direction perpendicular to the direction in which the terminal extends from the terminal side face, the case includes: a case hole (560) into which the terminal is inserted; a case inner surface (562) that forms the case hole and faces the terminal side face in a direction perpendicular to the direction in which the terminal extends; and a case recess (564) recessed from the case inner surface in a direction in which the terminal flange extends, and the case recess is in contact with the terminal flange to restrict movement of the terminal.

### [Aspect 12-2]

The current sensor of aspect 12-1, in which the terminal flange includes an exposed portion (7020) exposed to an outside by being exposed from the case recess.

### [Aspect 12-3]

The current sensor of aspect 12-1 or 12-2, in which the terminals are formed symmetrically in a direction in which the terminals extend, with the terminal flange as a center.

### [Aspect 12-4]

The current sensor according to any one of Aspects 12-1 to 12-3, in which the terminal includes a terminal hole (704) that is surrounded by the terminal flange and extends in a direction perpendicular to an extension direction of the terminal, the case includes an insertion portion (566) that protrudes from the case inner surface in a direction in which the terminal hole extends and is inserted into the terminal hole, and the insertion portion restricts movement of the terminal by being in contact with the terminal flange.

### [Aspect 12-5]

The current sensor of aspect 12-2, in which the case includes: an accommodation recess (570) accommodating a portion of the terminal; and a discharge portion (580) that is in communication with a space of the accommodation recess and the outside of the case, thereby discharging liquid flowing into the accommodation recess to the outside of the case, the accommodation recess includes: a recess bottom surface (572) intersecting with the thickness direction; a recess side face (574) that extends from the recess bottom surface in the thickness direction to form a space of the accommodation recess together with the recess bottom surface, the discharge portion penetrates the recess side face, the discharge portion includes a discharge surface (5800) that intersects with the thickness direction and is connected to the recess bottom surface, and the discharge surface is positioned on a ground (G) side than the exposed portion.

### [Aspect 12-6]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; a plurality of terminals (70) connected to the substrate; and a case (50) accommodating the bus bar, the core, the detection element, the lead wire, the substrate and the terminals, in which the terminal includes: a terminal side face (700) extending in the direction in which the terminal extends; and a terminal recess (706) that is recessed in a direction perpendicular to the direction in which the terminal extends from the terminal side face, the case includes: a case hole (560) into which the terminal is inserted; a case inner surface (562) that forms the case hole and faces the terminal side face in a direction perpendicular to the direction in which the terminal extends; and a case flange (568) protruding from the case inner surface in a direction in which the terminal recess is recessed, and the case flange restricts movement of the terminal by being is in contact with the terminal recess.

### (Subject)

According to a study by the inventor and others, when liquid such as water generated by condensation due to the usage environment of the current sensor remains in the connection terminal of a current sensor such as the one described in Patent Literature 1, the connection terminal corrodes. An object of the present disclosure is to provide a current sensor that suppresses corrosion of a terminal.

### [Aspect 13-1]

A current sensor including: a bus bar (10) formed in a plate shape and having a current path portion (100) through which an electric current flows; a core (20) including a core hole (24) into which the current path portion is inserted, a gap forming portion (21) including a first end face (211) facing in a width direction (DW) of the current path portion, a second end face (212) facing the first end face in the width direction, and a gap (213) formed by the first end face and the second end face and communicating with the core hole and the outside, a core side portion (22) connected to the gap forming portion and extending in a thickness direction (DT) of the current path portion, and a core bottom portion (23) connected to the core side portion and extending in the width direction and forming the core hole together with the gap forming portion and the core side portion; a detection element (31) arranged in the gap and configured to detect an intensity of a magnetic field generated by the electric current flowing through the current path portion; a lead wire (35) connected to the detection element; a substrate (40) connected to the lead wire; a terminal (70) connected to the substrate; and a case (50) accommodating the bus bar, the core, the detection element, the lead wire and the substrate, in which the case includes: a case recess (570) accommodating a portion of the terminal; and a discharge portion (580) discharging liquid flowing into the case recess to an outside of the case by being in communication with a space of the case recess and the outside of the case.

### [Aspect 13-2]

The current sensor of aspect 13-1, in which the case recess includes: a recess bottom surface (572) intersecting with the thickness direction; and a recess side face (574) that extends from the recess bottom surface in the thickness direction to form a space of the case recess together with the recess bottom surface, a length of the case in the width direction is longer than a length of the case in a longitudinal direction (DL) of the bus bar, and the discharge portion penetrates the recess side face in the width direction.

### [Aspect 13-3]

The current sensor of aspect 13-1 or 13-2, in which the case is formed of resin.

## Claims

1. A current sensor comprising:
a bus bar (10) in a plate shape and including a current path portion (100) configured to cause an electric current to flow therethrough;
a core (20) including
a core hole (24) into which the current path portion is inserted,
a gap forming portion (21) having
a first end face (211) facing in a width direction (DW) of the current path portion,
a second end face (212) facing the first end face in the width direction, and
a gap (213) defined by the first end face and the second end face and communicating with the core hole and an outside,
a core side portion (22) connected to the gap forming portion and extending in a thickness direction (DT) of the current path portion, and
a core bottom portion (23) connected to the core side portion, extending in the width direction, and defining the core hole with the gap forming portion and the core side portion;
a detection element (31) arranged in the gap and configured to detect an intensity of a magnetic field generated by an electric current flowing through the current path portion; and
a case (50) accommodating a portion of the bus bar, the core, and the detection element, wherein
the bus bar includes
a side face (111) that is of the current path portion and intersects with the width direction,
a first extension portion (121) that extends in the width direction from a region of the side face where the current path portion protrudes from the case, and
a second extension portion (122) that is connected to the first extension portion and extends in a direction intersecting with an extending direction in which the first extension portion extends, and
the second extension portion is configured to deform in the thickness direction while coming into contact with the case when the current path portion deforms in the thickness direction.

2. The current sensor according to claim 1, wherein
the side face is a first side face,
the bus bar includes
a second side face (112) of the current path portion that is positioned on an opposite side to the first side face and intersects with the width direction,
a third extension portion (123) that extends in the width direction from a region of the second side face where the current path portion protrudes from the case, and
a fourth extension portion (124) that is connected to the third extension portion and extends in a direction intersecting with an extending direction in which the third extension portion extends, wherein
the fourth extension portion is configured to deform in the thickness direction while coming into contact with the case when the current path portion deforms in the thickness direction.

3. The current sensor according to claim 1 or 2, wherein
the case includes
a case outer surface (590) that is an outer surface of the case intersecting with a longitudinal direction (DL) of the current path portion,
a case extension portion (581) extending from the case outer surface in the longitudinal direction, and
a claw portion (591) connected to the case extension portion and extending from the case extension portion in a direction intersecting with the direction in which the case extension portion extends, wherein
the claw portion is in contact with the second extension portion to restrict movement of the bus bar in the width direction and the longitudinal direction.

4. The current sensor according to claim 3, wherein
the case extension portion is configured to deform when the bus bar is inserted into the case.

5. The current sensor according to claim 3, wherein
the case extension portion is positioned outside relative to the second extension portion in the width direction, and
the claw portion extends in the width direction from the case extension portion.

6. The current sensor according to claim 1 or 2, wherein
the case includes
a case outer surface (572) which is an outer surface of the case intersecting with a longitudinal direction (DL) of the current path portion,
a case extension portion (581) extending from the case outer surface in the longitudinal direction, and
a claw portion (591) connected to the case extension portion and extending from the case extension portion in a direction intersecting with the direction in which the case extension portion extends, wherein
the claw portion is in contact with the first extension portion to restrict movement of the bus bar in the width direction and the longitudinal direction.

7. The current sensor according to claim 1 or 2, wherein
the case has
a hole (531) into which at least a portion of the second extension portion is inserted,
an inner surface (521) defining the hole and faces the second extension portion in the width direction and the thickness direction, and
a protrusion (541) protruding from the inner surface toward the second extension portion and in contact with the second extension portion.

8. The current sensor according to claim 1 or 2, wherein
a length of the second extension portion in the width direction is shorter than a length of the current path portion in the width direction.

9. A current sensor comprising:
a bus bar (10) in a plate shape and including a current path portion (100) configured to cause an electric current to flow therethrough;
a core (20) including
a core hole (24) into which the current path portion is inserted,
a gap forming portion (21) having
a first end face (211) facing in a width direction (DW) of the current path portion,
a second end face (212) facing the first end face in the width direction, and
a gap (213) defined by the first end face and the second end face and communicating with the core hole and an outside,
a core side portion (22) connected to the gap forming portion and extending in a thickness direction (DT) of the current path portion, and
a core bottom portion (23) connected to the core side portion, extending in the width direction, and defining the core hole with the gap forming portion and the core side portion;
a detection element (31) arranged in the gap and configured to detect an intensity of a magnetic field generated by an electric current flowing through the current path portion; and
a case (50) accommodating a portion of the bus bar, the core, and the detection element, wherein
the bus bar includes
a side face (111) that is of the current path portion and intersects with the width direction,
a first extension portion (121) that extends in the width direction from a region of the side face where the current path portion protrudes from the case, and
a second extension portion (122) that is connected to the first extension portion and extends in a direction intersecting with an extending direction in which the first extension portion extends, and
a cross-sectional area of the second extension portion taken along a direction perpendicular to a longitudinal direction (DL) of the current path portion is smaller than a cross-sectional area of the current path portion taken along the direction perpendicular to the longitudinal direction.

10. A current sensor comprising:
a bus bar (10) in a plate shape and including a current path portion (100) configured to cause an electric current to flow therethrough;
a core (20) including
a core hole (24) into which the current path portion is inserted,
a gap forming portion (21) having
a first end face (211) facing in a width direction (DW) of the current path portion,
a second end face (212) facing the first end face in the width direction, and
a gap (213) defined by the first end face and the second end face and communicating with the core hole and an outside,
a core side portion (22) connected to the gap forming portion and extending in a thickness direction (DT) of the current path portion, and
a core bottom portion (23) connected to the core side portion, extending in the width direction, and defining the core hole with the gap forming portion and the core side portion;
a detection element (31) arranged in the gap and configured to detect an intensity of a magnetic field generated by an electric current flowing through the current path portion; and
a case (50) accommodating a portion of the bus bar, the core, and the detection element, wherein
the bus bar includes
a side face (111) that is of the current path portion and intersects with the width direction, a first extension portion (121) that extends in the width direction from a region of the side face where the current path portion protrudes from the case,
an intermediate portion (151) that is connected to the first extension portion and extends in a direction intersecting with an extending direction in which the first extension portion extends, and
a second extension portion (122) that is connected to the intermediate portion and extends in a direction intersecting with an extending direction in which the the intermediate portion extends, and
the second extension portion is configured to deform in the thickness direction while coming into contact with the case when the current path portion deforms in the thickness direction.
